# EUROPEAN PATENT SPECIFICATION

(11) **EP 4 577 010 B1**
(45) Date of publication and mention of the grant of the patent: **18.11.2026**
(21) Application number: 24219043.7
(22) Date of filing: 11.12.2024
(51) Int. Cl.: H10H 29/32, H10H 29/49

(54) **DISPLAY DEVICE**
ANZEIGEVORRICHTUNG
DISPOSITIF D'AFFICHAGE

(30) Priority: 22.12.2023 KR 20230189931
(43) Date of publication of application: 25.06.2025
(73) Proprietor: Samsung Display Co., Ltd., Yongin-si, Gyeonggi-do 17113 (KR)
(72) Inventor: KIM, Buem Joon, 17113 Yongin-si (KR); IM, Hyun Deok, 17113 Yongin-si (KR)
(74) Representative: Walaski, Jan Filip

(56) References cited:
- EP-A1- 4 075 502
- EP-A1- 4 207 292
- US-A1- 2019 115 370
- US-A1- 2021 091 260
- US-A1- 2021 151 499
- US-A1- 2023 317 882

## Description

### BACKGROUND

### 1. Field

The present invention relates to a display device.

### 2. Description of Related Art

Recently, as interest in information display increases, research and development on display devices has been continuously conducted.

US 2021/151499 A1 and US 2023/317882 A1 each disclose a display device comprising a light emitting element and a transistor having an oxide semiconductor as an active material layer.

### SUMMARY

One or more embodiments of the present invention are directed to a display device with improved fabrication efficiency.

The present invention provides a display device according to claim 1.

- **[0024]**

### BRIEF DESCRIPTION OF THE DRAWINGS

FIG. 1 is a schematic perspective view illustrating a light-emitting element.
FIG. 2 is a schematic cross-sectional view illustrating the light-emitting element of FIG. 1.
FIG. 3 is a schematic plan view illustrating a display device.
FIG. 4 is a schematic cross-sectional view illustrating a display panel of FIG. 3.
FIG. 5 is a schematic circuit diagram illustrating an electrical connection relationship of components included in each of the pixels illustrated in FIG. 3.
FIG. 6 is a schematic plan view illustrating a pixel.
FIG. 7 is a schematic plan view illustrating a first sub-pixel of FIG. 6.
FIG. 8 is a schematic plan view illustrating only components included in a first conductive layer in the pixel of FIG. 6.
FIG. 9A is a schematic plan view illustrating alignment electrodes, light-emitting elements, and a first bank in the pixel of FIG. 6.
FIG. 9B is a schematic plan view illustrating alignment lines before portions of alignment electrodes are removed in FIG. 9A.
FIG. 10 is a schematic plan view illustrating transistors, a first electrode, and a second electrode in the pixel of FIG. 6.
FIG. 11 is a schematic plan view illustrating only components included in a fourth conductive layer in the pixel of FIG. 6.
FIG. 12 is a schematic cross-sectional view taken along the line I-I' of FIG. 7.
FIG. 13 is a schematic cross-sectional view taken along the line II-II' of FIG. 7.
FIGS. 14 - 22 are diagrams for describing a method of fabricating the first sub-pixel, and are schematic cross-sectional views corresponding to the line I-I' of FIG. 7.
FIG. 23 illustrates the first sub-pixel, and is a schematic cross-sectional view corresponding to the line I-I' of FIG. 7.

### DETAILED DESCRIPTION

As the present invention allows for various changes and numerous embodiments, particular embodiments will be illustrated in the drawings and described in detail in the written description. However, this is not intended to limit the present invention to particular modes of practice, and it is to be appreciated that all changes and substitutes that do not depart from the scope of the present invention as defined by the claims, are encompassed by the present invention.

Throughout the written description, like reference numerals refer to like parts throughout the various figures and embodiments of the present invention. The sizes of elements in the accompanying drawings may be exaggerated for clarity of illustration. It will be understood that, although the terms "first", "second", etc. may be used herein to describe various elements, these elements should not be limited by these terms. These terms are only used to distinguish one element from another element. For instance, a first element discussed below could be termed a second element without departing from the teachings of the present disclosure. Similarly, the second element could also be termed the first element.

It will be further understood that the terms "comprise", "include", "have", etc. when used in the present disclosure, specify the presence of stated aspects, integers, steps, operations, elements, components, and/or combinations of them but do not preclude the presence or addition of one or more other aspects, integers, steps, operations, elements, components, and/or combinations thereof. Furthermore, in case that a first part such as a layer, a film, a region, or a plate is located on a second part, the first part may be not only directly on the second part but a third part may intervene between them. In addition, in case that it is expressed that a first part such as a layer, a film, a region, or a plate is formed on a second part, the surface of the second part on which the first part is formed is not limited to an upper surface of the second part but may include other surfaces such as a side surface or a lower surface of the second part. To the contrary, in case that a first part such as a layer, a film, a region, or a plate is under a second part, the first part may be not only directly under the second part but a third part may intervene between them.

It will be understood that when an element (e.g., a first element) is referred to as being (operatively or communicatively) "coupled with/to," or "connected with/to" another element (e.g., a second element), the first element can be coupled or connected with/to the second element directly or via another element (e.g., a third element). In contrast, it will be understood that when an element (e.g., a first element) is referred to as being "directly coupled with/to" or "directly connected with/to" another element (e.g., a second element), no other element (e.g., a third element) intervenes between the element and the other element.

Embodiments and required details of the present invention are described with reference to the accompanying drawings in order to describe the present invention in detail so that those having ordinary knowledge in the technical field to which the present invention pertains can practice the present invention. Furthermore, a singular form may include a plural form as long as it is not specifically mentioned in a sentence.

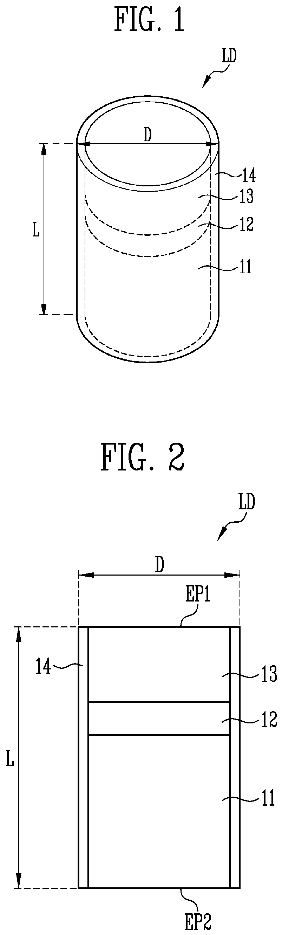

FIG. 1 is a schematic perspective view illustrating a light-emitting element LD. FIG. 2 is a schematic cross-sectional view illustrating the light-emitting element LD of FIG. 1.

Referring to FIGS. 1 and 2, the light-emitting element LD may include a first semiconductor layer 11, a second semiconductor layer 13, and an active layer 12 interposed between the first and second semiconductor layers 11 and 13. For example, the light-emitting element LD may be implemented as an emission stack (or referred to as a "stack pattern") formed by successively stacking the first semiconductor layer 11, the active layer 12, and the second semiconductor layer 13. The type and/or shape of the light-emitting element LD is not limited to that illustrated in FIG. 1.

The light-emitting element LD may be formed in a shape extending in one direction, which may be referred to as an elongate shape. If the direction in which the light-emitting element LD extends is defined as a longitudinal direction, the light-emitting element LD may have a first end EP1 and a second end EP2 that are opposite to each other along the longitudinal direction. One semiconductor layer of the first semiconductor layer 11 and the second semiconductor layer 13 may be located at the first end EP1 of the light-emitting element LD, and the other semiconductor layer of the first semiconductor layer 11 and the second semiconductor layer 13 may be located at the second end EP2 of the light-emitting element LD. For example, the second semiconductor layer 13 may be located at the first end EP1 of the light-emitting element LD, and the first semiconductor layer 11 may be located at the second end EP2 of the light-emitting element LD.

The light-emitting element LD may be provided in various shapes. For example, as illustrated in FIG. 1, the light-emitting element LD may have a rod-like shape, a bar-like shape, or a pillar-like shape which is longer than it is wide (for example, to have an aspect ratio greater than 1). Alternatively, the light-emitting element LD may have a rod-like shape, a bar-like shape, and/or a pillar-like shape which is shorter than it is wide (for example, to have an aspect ratio less than 1). As a further alternative, the light-emitting element LD may have a rod-like shape, a bar-like shape, and/or a pillar-like shape having an aspect ratio of 1.

The light-emitting element LD may include a light emitting diode (LED) fabricated to have a subminiature size, e.g., with a diameter D and/or a length L corresponding to a range from the nano scale (or the nanometer scale) to the micro scale (or the micrometer scale).

In case that the light-emitting element LD is longer than it is wide (e.g., to have an aspect ratio greater than 1), the diameter D of the light-emitting element LD may approximately range from about 0.5 µm to about 6 µm, and the length L thereof may approximately range from about 1 µm to about 10 µm. However, the diameter D and the length L of the light-emitting element LD are not limited thereto. The size of the light-emitting element LD may be changed to meet requirements (or design conditions) of a lighting device or a self-emissive display device to which the light-emitting element LD is applied.

The first semiconductor layer 11 may include, for example, at least one n-type semiconductor layer. For instance, the first semiconductor layer 11 may include an n-type semiconductor layer which includes at least one semiconductor material of InAlGaN, GaN, AlGaN, InGaN, AIN, and/or InN and is doped with a first conductive dopant (or an n-type dopant) such as Si, Ge, and/or Sn. However, the constituent material of the first semiconductor layer 11 is not limited to thereto, and various other materials may be used to form the first semiconductor layer 11. The active layer 12 may be located on the first semiconductor layer 11 and have a single- or multi-quantum well structure. For example, in the case in which the active layer 12 has a multiple quantum well structure, the active layer 12 may be formed by periodically repeatedly stacking a barrier layer, a stain reinforcing layer, and/or a well layer as one unit. However, the structure of the active layer 12 is not limited to that of the foregoing.

The active layer 12 may emit light having a wavelength ranging from 400 nm to 900 nm, and have a double hetero structure. A clad layer doped with a conductive dopant may be formed over or under the active layer 12 along the longitudinal direction of the light-emitting element LD. For example, the clad layer may be formed of an AlGaN layer and/or an InAlGaN layer. Material such as AlGaN and/or InAlGaN may be used to form the active layer 12, and various other materials may be used to form the active layer 12. The active layer 12 may include a first surface which contacts the first semiconductor layer 11, and a second surface which contacts the second semiconductor layer 13.

If an electric field having a certain voltage or more is applied to the opposite ends of the light-emitting element LD, the light-emitting element LD may emit light by coupling of electron-hole pairs in the active layer 12. Because light emission of the light-emitting element LD can be controlled based on the foregoing aspects, the light-emitting element LD may be used as a light source (e.g., a light emitting source) of various light emitting devices as well as a pixel of a display device.

The second semiconductor layer 13 may be located on the second surface of the active layer 12 and include a semiconductor layer of a type different from that of the first semiconductor layer 11. For example, the second semiconductor layer 13 may include at least one p-type semiconductor layer. For instance, the second semiconductor layer 13 may include a p-type semiconductor layer which includes at least one semiconductor material of InAlGaN, GaN, AlGaN, InGaN, AIN, and/or InN, and is doped with a second conductive dopant (or a p-type dopant) such as Mg, Zn, Ca, Sr, and/or Ba. However, the material for forming the second semiconductor layer 13 is not limited thereto, and various other materials may be used to form the second semiconductor layer 13.

The first semiconductor layer 11 and the second semiconductor layer 13 may have different thicknesses in the longitudinal direction of the light-emitting element LD. For example, the first semiconductor layer 11 may have a thickness greater than that of the second semiconductor layer 13 in the longitudinal direction of the light-emitting element LD. Hence, the active layer 12 of the light-emitting element LD may be located at a position closer to the upper surface of the second semiconductor layer 13 than to the lower surface of the first semiconductor layer 11.

Although FIGS. 1 and 2 illustrate that each of the first semiconductor layer 11 and the second semiconductor layer 13 is formed of a single layer, the present disclosure is not limited thereto. Depending on the material of the active layer 12, each of the first semiconductor layer 11 and the second semiconductor layer 13 may further include at least one or more layers, for example, a clad layer and/or a tensile strain barrier reducing (TSBR) layer. The TSBR layer may be a strain relief layer which is located between semiconductor layers having different lattice structures and thus can function as a buffer layer to reduce a difference in lattice constant. Although the TSBR layer may be formed of a p-type semiconductor layer such as p-GaInP, p-AlInP, or p-AlGaInP, it is not limited thereto.

The light-emitting element LD may further include a contact electrode (hereinafter referred to as "first contact electrode") located over the second semiconductor layer 13, as well as including the first semiconductor layer 11, the active layer 12, and the second semiconductor layer 13. Furthermore, the light-emitting element LD may further include an additional contact electrode (hereinafter referred to as "second contact electrode") located on one end of the first semiconductor layer 11.

Each of the first and second contact electrodes may be an ohmic contact electrode, but is not limited thereto. Each of the first and second contact electrodes may be a Schottky contact electrode. The first and second contact electrodes may include conductive material. For example, the first and second contact electrodes may include opaque metal such as chrome (Cr), titanium (Ti), aluminum (Al), gold (Au), nickel (Ni), and/or oxides or alloys thereof, which are used alone or in combination, but the present disclosure is not limited thereto. The first and second contact electrodes may also include transparent conductive oxides such as indium tin oxide (ITO), indium zinc oxide (IZO), zinc oxide (ZnOₓ), indium gallium zinc oxide (IGZO), and/or indium tin zinc oxide (ITZO). Here, the zinc oxide (ZnOₓ) may be zinc oxide (ZnO) and/or zinc peroxide (ZnO₂).

Materials included in the first and second contact electrodes may be identical to or different from each other. The first and second contact electrodes may be substantially transparent or translucent.

The light-emitting element LD may further include an insulating layer 14. However, the insulating layer 14 may be omitted, or may be provided to cover only some of the first semiconductor layer 11, the active layer 12, and the second semiconductor layer 13.

The insulating layer 14 may prevent the active layer 12 from short-circuiting due to making contact with conductive material except the first and second semiconductor layers 11 and 13. Furthermore, the insulating layer 14 may reduce or minimize a surface defect of the light-emitting element LD, thus enhancing the lifetime and emission efficiency of the light-emitting element LD. In the case in which a plurality of light-emitting elements LD are located in close contact with each other, the insulating layer 14 may prevent an undesired short-circuit from occurring between the light-emitting elements LD. The presence or non-presence of the insulating layer 14 is not limited, so long as the active layer 12 can be prevented from short-circuiting with external conductive material.

The insulating layer 14 may be provided to enclose an overall outer surface (e.g., an overall outer peripheral or circumferential surface) of the emission stack including the first semiconductor layer 11, the active layer 12, and the second semiconductor layer 13.

Although in the foregoing the insulating layer 14 has been described as enclosing the entirety of the outer surface (e.g., outer peripheral or circumferential surface) of each of the first semiconductor layer 11, the active layer 12, and the second semiconductor layer 13, it is not limited thereto. In the case in which the light-emitting element LD includes the first contact electrode, the insulating layer 14 may enclose the entirety of the respective outer surfaces (e.g., outer peripheral or circumferential surfaces) of the first semiconductor layer 11, the active layer 12, the second semiconductor layer 13, and the first contact electrode. The insulating layer 14 may not enclose the entirety of the outer surface (e.g., outer peripheral or circumferential surface) of the first semiconductor layer 11, or may enclose only a portion of the outer surface (e.g., outer peripheral or circumferential surface) of the first semiconductor layer 11 without enclosing the other portion of the outer surface (e.g., outer peripheral or circumferential surface) of the first semiconductor layer 11. Furthermore, in the case in which the first contact electrode is located at the first end EP1 of the light-emitting element LD and the second contact electrode is located at the second end EP2 of the light-emitting element LD, the insulating layer 14 may allow at least one area of each of the first and/or second contact electrodes to be exposed.

The insulating layer 14 may include transparent insulating material. Various materials having insulation properties may be used as the material of the insulating layer 14.

The insulating layer 14 may have a single-layer structure or a multilayer structure including a double-layer structure. For example, in the case in which the insulating layer 14 is formed of a double-layer structure including a first layer and a second layer that are successively stacked, the first layer and the second layer may be made of different materials (or substances) and may be formed through different processes. The first layer and the second layer may include the same material and may be formed through successive processes.

The light-emitting element LD may be implemented as a light emitting pattern having a core-shell structure.

The light-emitting element LD may be employed as a light emitting source (or a light source) for various display devices. The light-emitting element LD may be fabricated through a surface treatment process.

An emission component including the light-emitting element LD described above may be used not only in a display device but also in various electronic devices which requires a light source.

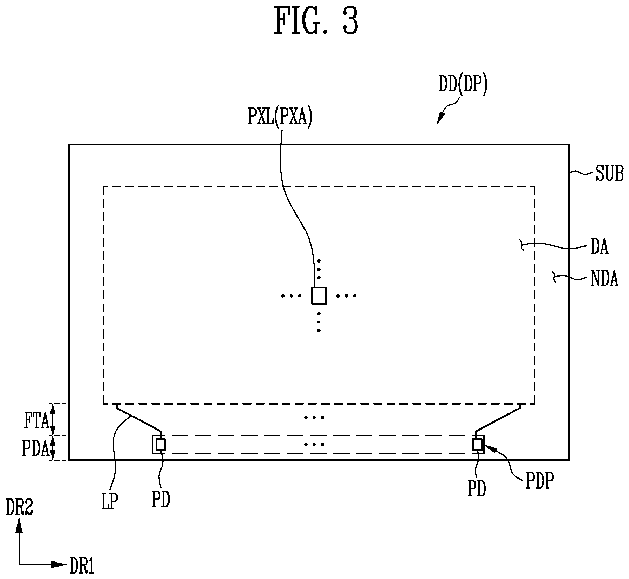

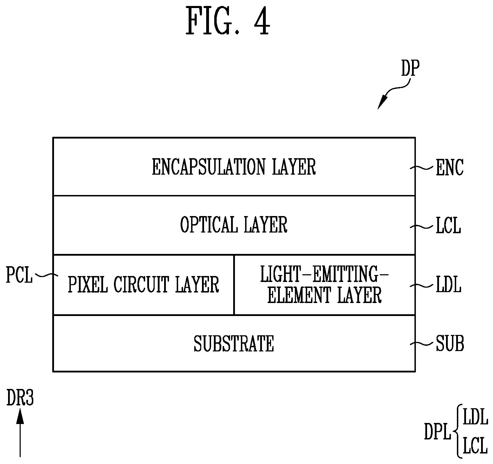

FIG. 3 is a schematic plan view illustrating a display device DD. FIG. 4 is a schematic cross-sectional view illustrating a display panel DP of FIG. 3.

In FIGS. 3 and 4, for convenience, there is schematically illustrated the display device DD, for example, the structure of the display panel DP provided in the display device DD, centered on a display area DA in which an image is displayed.

Referring to FIGS. 1 - 4, the display device DD may include a substrate SUB, pixels PXL provided on the substrate SUB and each including at least one light-emitting element LD, a driver provided on the substrate SUB and configured to drive the pixels PXL, and/or a line component provided to connect the pixels PXL with the driver.

The display device DD may be classified into a passive matrix type display device and/or an active matrix type display device according to a method of driving the light-emitting element LD. For example, in case that the display device DD is implemented as an active matrix type, each of the pixels PXL may include a driving transistor configured to control the amount of current to be supplied to the light-emitting element LD, and a switching transistor configured to transmit a data signal to the driving transistor.

The display panel DP (or the display device DD) may include a substrate SUB, and pixels PXL provided on the substrate SUB. Each of the pixels PXL may include at least one light-emitting element LD.

The substrate SUB may include transparent insulating material to allow light transmission. The substrate SUB may be a rigid substrate and/or a flexible substrate.

For example, the rigid substrate may be one of a glass substrate, a quartz substrate, a glass ceramic substrate, and/or a crystalline glass substrate.

The flexible substrate may be either a film substrate or a plastic substrate which includes polymer organic material. For example, the flexible substrate SUB may include at least one of the following: polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, and/or cellulose acetate propionate.

One area on the substrate SUB may be provided as the display area DA in which the pixels PXL are located, and the other area on the substrate SUB may be provided as the non-display area NDA. For example, the substrate SUB may include the display area DA including a plurality of pixel areas PXA on which the respective pixels PXL are located, and the non-display area NDA located around an edge or a perimeter of the display area DA (or adjacent to the display area DA).

The non-display area NDA may be provided on at least one side of the display area DA. The non-display area NDA may enclose the perimeter (or edges) of the display area DA. Portions of the line component connected to the pixels PXL, and the driver connected to the line component and configured to drive the pixels PXL may be provided in the non-display area NDA.

The non-display area NDA may be an area in which certain lines (e.g., fan-out lines LP), pads PD, and/or an internal circuit component that are electrically connected with the pixels PXL to drive the pixels PXL are provided.

The non-display area NDA may include a fan-out area FTA and a pad area PDA.

The pad area PDA may be one area of the non-display area NDA in which the pad component PDP is positioned, and may be located most adjacent to (closest to) a perimeter (or an edge) of the non-display area NDA. The fan-out area FTA may be another area of the non-display area NDA in which the fan-out lines LP that are portions of the line component are located, and may be located adjacent to the display area DA in the non-display area NDA. For example, the fan-out area FTA may be one area of the non-display area NDA that is located between the pad area PDA and the display area DA. The non-display area NDA may include an antistatic circuit area in which there is located an antistatic circuit which is electrically connected to signal lines located in the display area DA and is configured to prevent static electricity from occurring. The antistatic circuit area may be one area of the non-display area NDA between the display area DA and the fan-out area FTA, but is not limited thereto.

The pad component PDP may be located in the pad area PDA. The fan-out lines LP, which are portions of the line component, may be located in the fan-out area FTA.

The fan-out lines LP may be electrically connected to the pixels PXL so that certain signals applied from the driver may be transmitted to the pixels PXL. The fan-out lines LP may be located in the fan-out area FTA and electrically connect the driver to the pixels PXL.

The pad component PDP may include a plurality of pads PD. The pads PD may supply (or transmit) driving power voltages and signals for driving the pixels PXL provided in the display area DA and/or the internal circuits. In the case in which the driver is mounted in the non-display area NDA of the substrate SUB, the pad component PDP may overlap output pads of the drivers and may be supplied with signals outputted from the driver.

Each of the pixels PXL may be located in the pixel area PXA. The pixels PXL may be arranged in the display area DA in a stripe arrangement manner or the like, but the arrangement is not limited thereto.

Each of the pixels PXL may include a pixel circuit layer PCL, a display element layer DPL, and an encapsulation layer ENC, which are located on the substrate SUB.

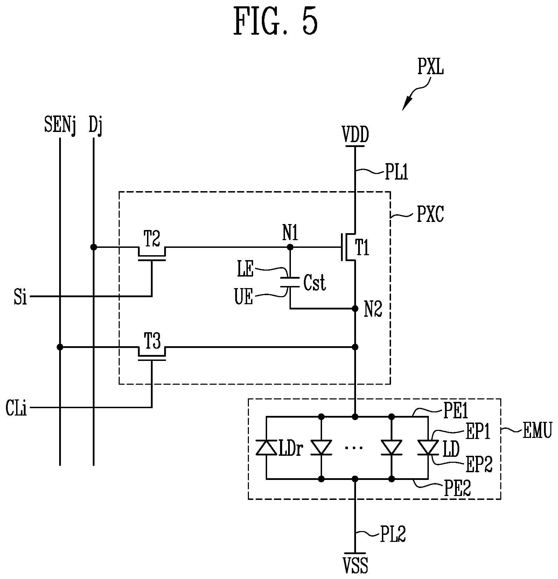

A pixel circuit (refer to "PXC" of FIG. 5) which is provided on the substrate SUB and includes a plurality of transistors, signal lines electrically connected to the transistors, and a plurality of insulating layers may be located in the pixel circuit layer PCL. Each of the transistors has a structure in which, for example, a semiconductor pattern, a gate electrode, a first terminal, and a second terminal are successively stacked with insulating layers interposed therebetween. The semiconductor pattern may include amorphous silicon, poly silicon, low temperature poly silicon, and/or an organic semiconductor, and/or an oxide semiconductor. Although each of the gate electrode, the first terminal (or the source electrode), and the second terminal (or the drain electrode) may include one of aluminum (Al), copper (Cu), titanium (Ti), and/or molybdenum (Mo), they not limited thereto.

The display element layer DPL may include a light-emitting-element layer LDL and an optical layer LCL.

The light-emitting-element layer LDL may be located on the substrate SUB. The light-emitting-element layer LDL may be located on the same surface as the pixel circuit layer PCL, and may be spaced apart from the pixel circuit layer PCL without overlapping the pixel circuit layer PCL. An emission component (refer to "EMU" of FIG. 5) including a light-emitting element LD configured to emit light may be located in the light-emitting-element layer LDL. A first electrode (refer to "PE1" of FIG. 5) and a second electrode (refer to "PE2" of FIG. 5) that are electrically connected to the light-emitting element LD may be located in the emission component EMU.

The optical layer LCL may convert light which is emitted from the light-emitting-element layer LDL and travels in an upward direction (or a third direction DR3) of the substrate SUB to light having excellent color reproducibility, and then emit the converted light. The optical layer LCL may include a color filter layer and a color conversion layer.

The encapsulation layer ENC may be located on the display element layer DPL (or the optical layer LCL). The encapsulation layer ENC may mitigate a step difference caused by components located thereunder, e.g., the optical layer LCL, and may prevent external air, water, and/or the like from permeating the display element layer DPL. The encapsulation layer ENC may include material capable of absorbing and/or blocking light to prevent external light from being introduced into the display element layer DPL. For example, the encapsulation layer ENC may include a black matrix, but is not limited thereto.

FIG. 5 is a schematic circuit diagram illustrating an electrical connection relationship of components included in each of the pixels PXL illustrated in FIG. 3.

For example, FIG. 5 illustrates the electrical connection relationship of components included in the pixel PXL that may be employed in an active matrix type display device. Here, the connection relationship of the components of each pixel PXL is not limited thereto.

For convenience of description, FIG. 5 illustrates a pixel PXL (or a sub-pixel) that is positioned at an i-th horizontal line (or an i-th pixel row) and connected to a j-th data line Dj (where i and j are natural numbers).

Referring to FIGS. 1 - 5, the pixel PXL (or the sub-pixel) may include an emission component EMU (or an emission unit) configured to generate light having a luminance corresponding to a data signal. Furthermore, the pixel PXL may selectively further include a pixel circuit PXC (or a pixel circuit component) configured to drive the emission component EMU.

The emission component EMU may include a plurality of light-emitting elements LD connected in parallel between a first power line PL1 to which a first driving voltage VDD is applied and a second power line PL2 to which a second driving voltage VSS is applied. For example, the emission component EMU may include a first electrode PE1 (or a first pixel electrode) connected to the pixel circuit PXC and the first power line PL1, a second electrode PE2 (or a second pixel electrode) connected to the second power line PL2 to receive the second driving voltage VSS, and a plurality of light-emitting elements LD connected in parallel to each other in the same direction between the first and second pixel electrodes PE1 and PE2. The first electrode PE1 may be an anode, and the second electrode PE2 may be a cathode.

The first driving voltage VDD and the second driving voltage VSS may have different potentials. Here, a difference in potential between the first driving voltage VDD and the second driving voltage VSS may be set to be equal to or greater than the threshold voltage of the light-emitting elements LD during an emission period of the pixel PXL.

Each of the light-emitting elements LD may include a first end EP1 (e.g., a p-type end) connected to at least one electrode (e.g., the first electrode PE1) and the pixel circuit PXC and/or the first power line PL1, and a second end EP2 (e.g., an n-type end) connected to at least one additional electrode (e.g., the second electrode PE2) and the second power line PL2. In other words, the light-emitting elements LD may be connected in a forward direction between the first driving voltage (power supply) VDD and the second driving voltage (power supply) VSS. The light-emitting elements LD connected in the forward direction may form valid light sources of the emission component EMU.

The light-emitting elements LD of the emission component EMU may emit light having a luminance corresponding to driving current supplied thereto through the pixel circuit PXC. For example, during each frame period, driving current that corresponds to a grayscale value of a corresponding frame data of the pixel circuit PXC may be supplied to the emission component EMU. The driving current supplied to the emission component EMU may be divided into parts which flow into the respective light-emitting elements LD. Hence, each of the light-emitting elements LD may emit light having a luminance corresponding to current applied thereto, so that the emission component EMU may emit light having a luminance corresponding to the driving current.

Although there has been described the implementation in which the opposite ends EP1 and EP2 of the light-emitting elements LD are connected in the same direction between the first and second driving voltages (power supplies) VDD and VSS, the present disclosure is not limited thereto. The emission component EMU may further include at least one invalid light source, e.g., a reverse light-emitting element LDr, as well as including the light-emitting elements LD that form the respective valid light sources. The reverse light-emitting element LDr, along with the light-emitting elements LD that form the valid light sources, may be connected in parallel to each other between the first and second electrodes PE1 and PE1. Here, the reverse light-emitting element LDr may be connected between the first and second electrodes PE1 and PE2 in a direction opposite to that of the light-emitting elements LD. Even if a driving voltage (e.g., a forward driving voltage) is applied between the first and second electrodes PE1 and PE2, the reverse light-emitting element LDr remains disabled. Hence, current substantially does not flow through the reverse light-emitting element LDr.

In the case in which the pixel PXL is located on an i-th pixel row and a j-th pixel column in the display area DA, the pixel circuit PXC of the pixel PXL may be electrically connected to an i-th scan line Si and a j-th data line Dj. Furthermore, the pixel circuit PXC may be electrically connected to an i-th control line CLi and a j-th sensing line SENj.

The pixel circuit PXC may include first to third transistors T1 to T3, and a storage capacitor Cst.

The first transistor T1 may be a driving transistor configured to control driving current to be applied to the emission component EMU, and may be connected between the first driving power supply VDD and the emission component EMU. In detail, a first terminal of the first transistor T1 may be electrically connected to the first power line PL1. A second terminal of the first transistor T1 may be electrically connected to a second node N2. A gate electrode of the first transistor T1 may be connected to a first node N1. The first transistor T1 may control, in response to a voltage applied to the first node N1, the amount of driving current to be applied from the first power line PL1 to the emission component EMU through the second node N2. The first terminal of the first transistor T1 may be a drain electrode, and the second terminal of the first transistor T1 may be a source electrode, and the present disclosure is not limited thereto. The first terminal may be a source electrode, and the second terminal may be a drain electrode.

The second transistor T2 may be a switching transistor configured to select a pixel PXL in response to a scan signal and activate the pixel PXL, and may be electrically connected between the j-th data line Dj and the first node N1. A first terminal of the second transistor T2 may be electrically connected to the j-th data line Dj. A second terminal of the second transistor T2 may be electrically connected to the first node N1. A gate electrode of the second transistor T2 may be electrically connected to the i-th scan line Si. The first terminal and the second terminal of the second transistor T2 are different terminals, and, for example, if the first terminal is a drain electrode, the second terminal may be a source electrode.

In case that a scan signal of a gate-on voltage (e.g., a high level voltage) is supplied from the i-th scan line Si, the second transistor T2 may be turned on to electrically connect the j-th data line Dj to the first node N1. The first node N1 may be a point at which the second terminal of the second transistor T2 and the gate electrode of the first transistor T1 are electrically connected to each other. The second transistor T2 may transmit a data signal to the gate electrode of the first transistor T1.

The third transistor T3 may acquire a sensing signal through the sensing line SENj by electrically connecting the first transistor T1 to the j-th sensing line SENj, and may detect, using the sensing signal, characteristics of the pixel PXL such as a threshold voltage of the first transistor T1. Information about the characteristics of the pixel PXL may be used to convert image data such that a deviation in characteristic between pixels PXL can be compensated for. A second terminal of the third transistor T3 may be electrically connected to the second terminal of the first transistor T1. A first terminal of the third transistor T3 may be electrically connected to the j-th sensing line SENj. A gate electrode of the third transistor T3 may be electrically connected to the i-th control line CLi. Furthermore, the first terminal of the third transistor T3 may be electrically connected to an initialization power line to which an initialization voltage is applied. The third transistor T3 may be an initialization transistor configured to initialize the second node N2, and may be turned on in case that a sensing control signal is supplied thereto from the i-th control line CLi, so that the initialization voltage can be transmitted to the second node N2.

The storage capacitor Cst may include a lower electrode LE (or a first capacitor electrode) and an upper electrode UE (or a second capacitor electrode). The lower electrode LE of the storage capacitor Cst may be electrically connected to the first node N1. The upper electrode UE of the storage capacitor Cst may be electrically connected to the second node N2. The storage capacitor Cst may be charged with a data voltage corresponding to a data signal to be supplied to the first node N1 during one frame period.

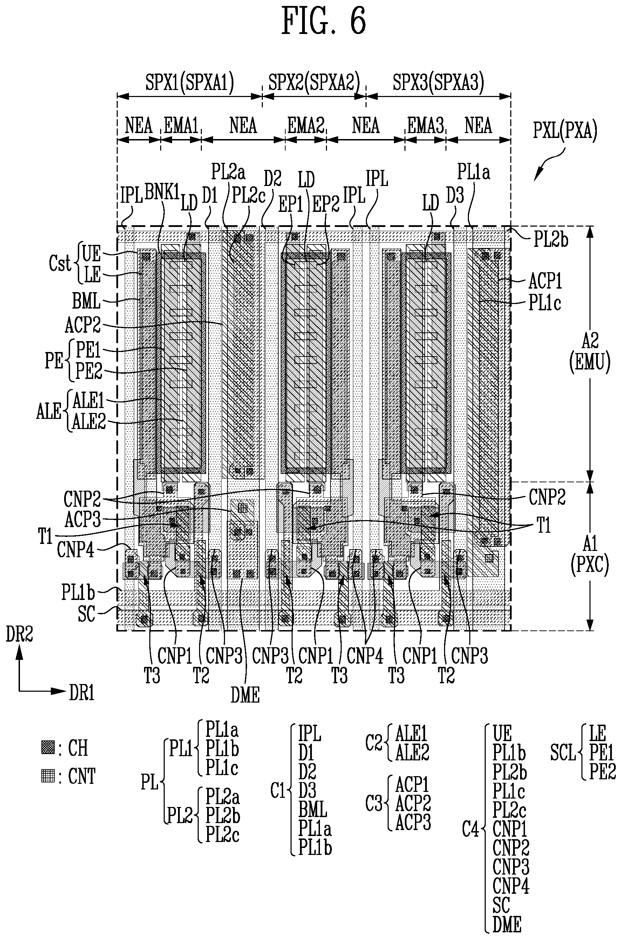

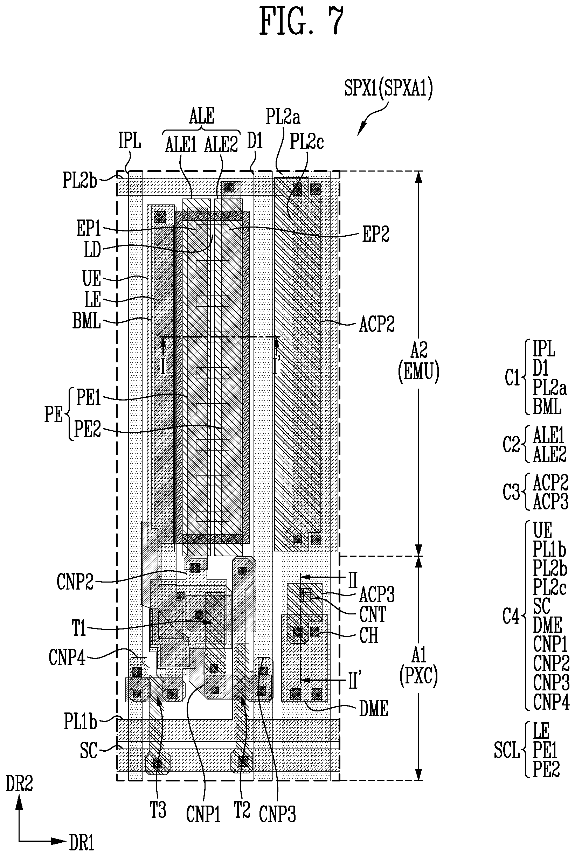

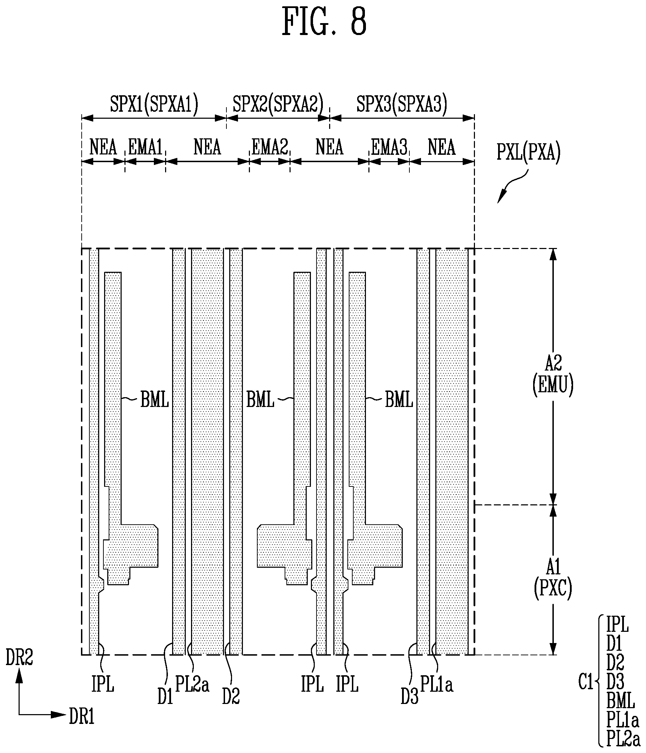

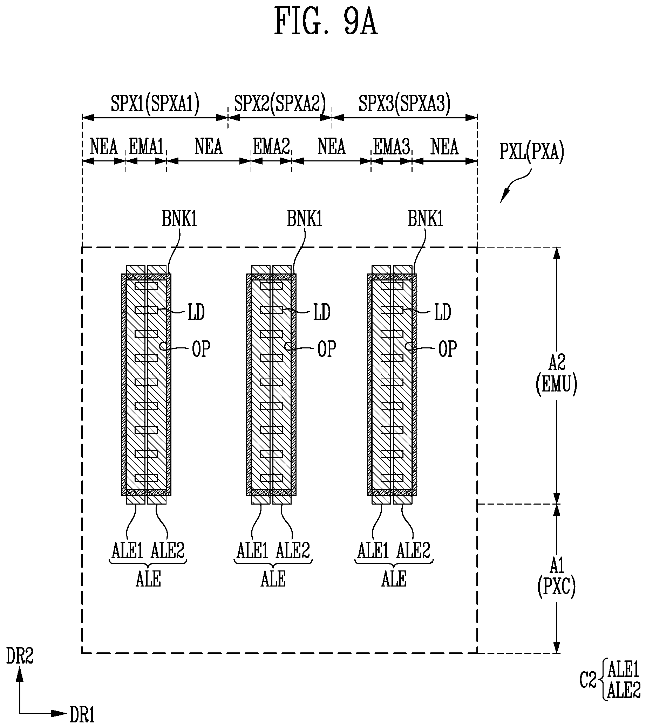

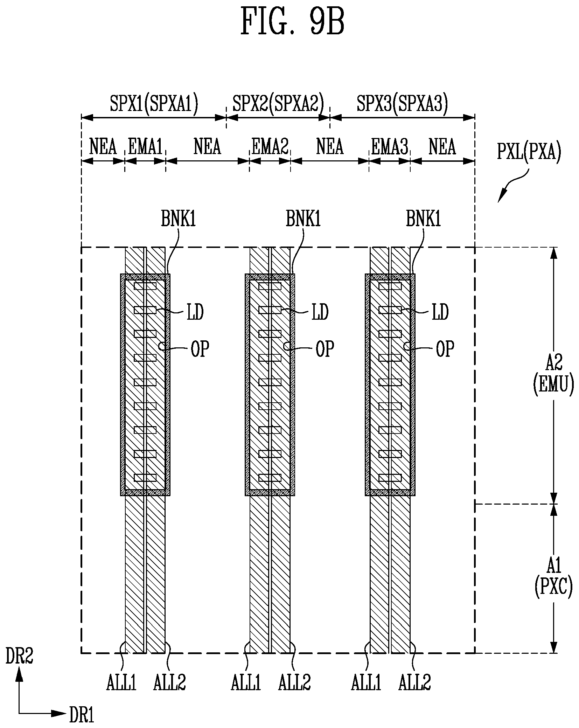

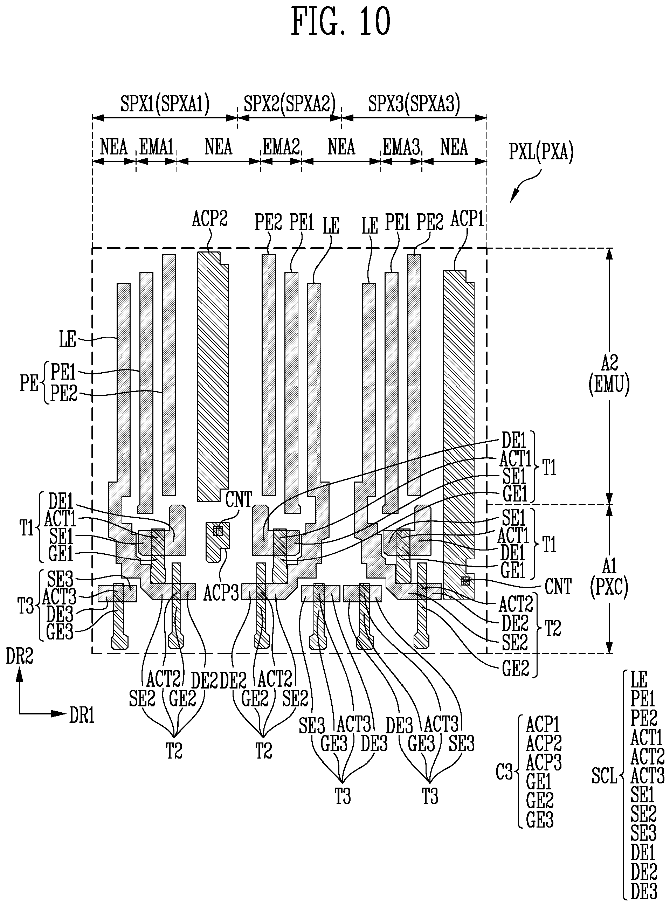

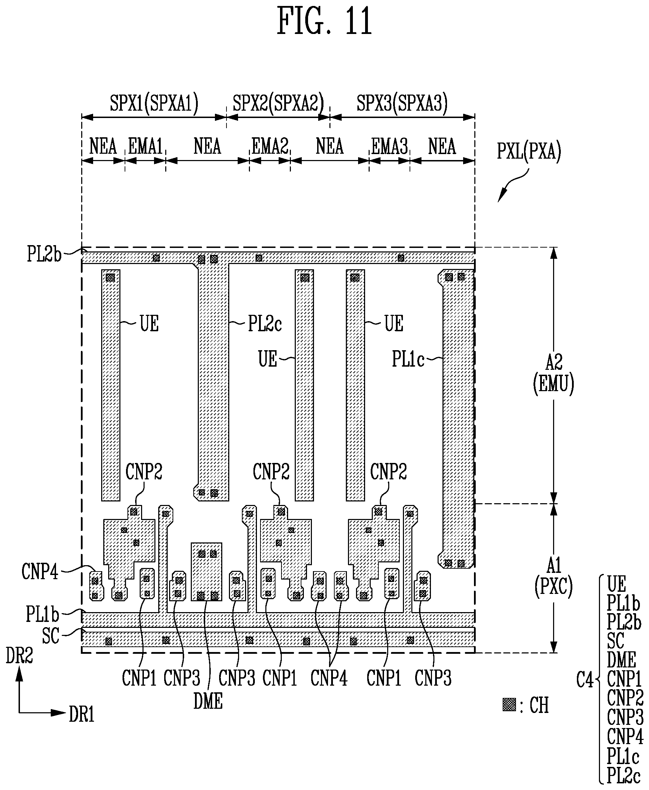

FIG. 6 is a schematic plan view illustrating a pixel PXL. FIG. 7 is a schematic plan view illustrating a first sub-pixel SPX1 of FIG. 6. FIG. 8 is a schematic plan view illustrating only components included in a first conductive layer C1 in the pixel PXL of FIG. 6. FIG. 9A is a schematic plan view illustrating alignment electrodes ALE, light-emitting elements LD, and a first bank BNK1 in the pixel PXL of FIG. 6. FIG. 9B is a schematic plan view illustrating alignment lines before portions of alignment electrodes are removed in FIG. 9A. FIG. 10 is a schematic plan view illustrating transistors, a first electrode PE1, and a second electrode PE2 in the pixel PXL of FIG. 6. FIG. 11 is a schematic plan view illustrating only components included in a fourth conductive layer C4 in the pixel PXL of FIG. 6.

In FIGS. 6 - 11, not only the components included in the pixel PXL but also an area in which the components are provided (or located) may be embraced in the definition of the term "pixel PXL".

Referring to FIGS. 1 - 11, the pixel PXL may be located in the pixel area PXA. The pixel PXL may include a first sub-pixel SPX1, a second sub-pixel SPX2, and a third sub-pixel SPX3.

The first sub-pixel SPX1 may be located in a first sub-pixel area SPXA1 of the pixel area PXA. The second sub-pixel SPX2 may be located in a second sub-pixel area SPXA2 of the pixel area PXA. The third sub-pixel SPX3 may be located in a third sub-pixel area SPXA3 of the pixel area PXA.

Each of the first to third sub-pixel areas SPXA1 to SPXA3 may include a first area A1 and a second area A2. For example, each of the first to third sub-pixel areas SPXA1 to SPXA3 may include the first area A1 and the second area A2 which are partitioned from each other in the second direction DR2. A pixel circuit PXC (or a pixel circuit component) of each of the first to third sub-pixels SPX1 to SPX3 may be located in the first area A1. An emission component EMU of each of the first to third sub-pixels SPX1 to SPX3 may be located in the second area A2. Furthermore, the second area A2 in which the emission component EMU is located may include an emission area of the corresponding sub-pixel. For example, the second area A2 of the first sub-pixel SPX1 may include a first emission area EMA1. The second area A2 of the second sub-pixel SPX2 may include a second emission area EMA2. The second area A2 of the third sub-pixel SPX3 may include a third emission area EMA3.

The pixel area PXA may include a non-emission area NEA that is adjacent to the first emission area EMA1 (or is positioned around the first emission area EMA1), a non-emission area NEA that is adjacent to the second emission area EMA2 (or is positioned around the edge or perimeter of the second emission area EMA2), and a non-emission area NEA that is adjacent to the third emission area EMA3 (or is positioned around the third emission area EMA3).

Signal lines that are electrically connected to the pixel circuit PXC of each of the first to third sub-pixels SPX1 to SPX3 may be located in the pixel area PXA. For example, an initialization power line IPL, data lines D1, D2, and D3, a power line PL, a scan line SC, and/or the like may be located in the pixel area PXA, but the present disclosure is not limited thereto.

The scan line SC may be selectively supplied with a scan signal and a sensing control signal. The scan line SC may extend in a first direction DR1. The scan line SC may be configured of the fourth conductive layer C4. The fourth conductive layer C4 (or a source-drain conductive layer) may be formed as a single-layer or multilayer structure formed of molybdenum, copper, aluminum, chromium, gold, silver, titanium, nickel, neodymium, indium, tin, and/or an oxide, and/or alloy thereof.

The scan line SC may be electrically connected to the second transistor T2 included in the pixel circuit PXC of each of the first to third sub-pixels SPX1 to SPX3. For example, the scan line SC may be electrically connected to a second gate electrode GE2 of the second transistor T2 of each of the first to third sub-pixels SPX1 to SPX3 through a corresponding contact hole CH. Furthermore, the scan line SC may be electrically connected to the third transistor T3 included in the pixel circuit PXC of each of the first to third sub-pixels SPX1 to SPX3. For example, the scan line SC may be electrically connected to a third gate electrode GE3 of the third transistor T3 of each of the first to third sub-pixels SPX1 to SPX3 through a corresponding contact hole CH.

The second gate electrode GE2 and the third gate electrode GE3 may be configured of a third conductive layer C3. The third conductive layer C3 (or a gate conductive layer) may include the same material as that of the fourth conductive layer C4, or may include one or more suitable (or selected) materials from among materials exemplified as the constituent material of the fourth conductive layer C4, but the present disclosure is not limited thereto.

The scan line SC may supply a scan signal to the second transistor T2 of the pixel circuit PXC of each of the first to third sub-pixels SPX1 to SPX3 during a driving period of the light-emitting elements LD, and may supply a sensing control signal to the third transistor T3 of the pixel circuit PXC during a sensing period.

The data lines D1, D2, and D3 may include a first data line D1, a second data line D2, and a third data line D3 which extend in the second direction DR2 and are arranged along the first direction DR1. A data signal may be applied to each of the first to third data lines D1, D2, and D3.

The first data line D1 may be electrically connected to the second transistor T2 of the pixel circuit PXC of the first sub-pixel SPX1. The second data line D2 may be electrically connected to the second transistor T2 of the pixel circuit PXC of the second sub-pixel SPX2. The third data line D3 may be electrically connected to the second transistor T2 of the pixel circuit PXC of the third sub-pixel SPX3. Each of the first, second, and third data lines D1, D2, and D3 may be formed of the first conductive layer C1. The first conductive layer C1 (or a bottom metal layer) may include the same material as that of the fourth conductive layer C4, or may include one or more suitable materials from among materials exemplified as the constituent material of the fourth conductive layer C4, but it is not limited thereto.

The power line PL may include a first power line PL1 and a second power line PL2.

The first power line PL1 may be supplied with the first driving voltage VDD. The first power line PL1 may include a first vertical power line PL1a, a first horizontal power line PL1b, and a first dummy power line PL1c.

The first vertical power line PL1a may extend in the second direction DR2, and may be formed of the first conductive layer C1. The first horizontal power line PL1b may extend in the first direction DR1, and may be formed of the fourth conductive layer C4. The first dummy power line PL1c may be formed of the fourth conductive layer C4, and may overlap the first vertical power line PL1a.

The first vertical power line PL1a formed of the first conductive layer C1 and the first dummy power line PL1c formed of the fourth conductive layer C4 may be electrically connected to each other through a corresponding contact hole. The first vertical power line PL1a and the first horizontal power line PL1b may be electrically connected to each other. The first vertical power line PL1a, the first horizontal power line PL1b, and the first dummy power line PL1c that are connected to each other may have a mesh structure in the pixel area PXA.

The first dummy power line PL1c may be electrically connected, through a corresponding contact hole CH, to a first additional conductive pattern ACP1 located in a different layer. The first additional conductive pattern ACP1 may be formed of the third conductive layer C3 and extend in the second direction DR2 to overlap the first dummy power line PL1c. The first dummy power line PL1c may be electrically connected, through a corresponding contactor CNT, to the first additional conductive pattern ACP1 located in the different layer. Furthermore, the first additional conductive pattern ACP1 may be electrically connected with the first vertical power line PL1a formed of the first conductive layer C1 through a corresponding contactor CNT.

In a plan view, the first vertical power line PL1a, the first additional conductive pattern ACP1, and the first dummy power line PL1c may overlap each other. Because the first vertical power line PL1a formed of the first conductive layer C1, the first additional conductive pattern ACP1 formed of the third conductive layer C3, and the first dummy power line PL1c formed of the fourth conductive layer C4 are electrically connected to each other, line resistance of the first power line PL1 may be reduced.

The second power line PL2 may be supplied with the second driving voltage VSS. The second power line PL2 may include a second vertical power line PL2a, a second horizontal power line PL2b, and a second dummy power line PL2c.

The second vertical power line PL2a may extend in the second direction DR2, and may be formed of the first conductive layer C1. The second horizontal power line PL2b may extend in the first direction DR1, and may be formed of the fourth conductive layer C4. The second dummy power line PL2c may be formed of the fourth conductive layer C4, and may extend in the second direction DR2 and overlap the second vertical power line PL2a. The second dummy power line PL2c may be one area of the second horizontal power line PL2b. The second vertical power line PL2b may be provided in a shape extending (or protruding) from the second dummy power line PL2c in the first direction DR1.

The second vertical power line PL2a formed of the first conductive layer C1 and the second dummy power line PL2c (or the second horizontal power line PL2b) formed of the fourth conductive layer C4 may be electrically connected to each other through a corresponding contact hole CH. Therefore, the second vertical power line PL2a, the second dummy power line PL2c, and the second horizontal power line PL2b may be electrically connected to each other. The second vertical power line PL2a, the second horizontal power line PL2b, and the second dummy power line PL2c that are connected to each other may have a mesh structure.

The second dummy power line PL2c may be electrically connected, through a corresponding contact hole CH, to a second additional conductive pattern ACP2 located in a different layer. The second additional conductive pattern ACP2 may be formed of the third conductive layer C3 and extend in the second direction DR2 to overlap the second dummy power line PL2c. Because the second dummy power line PL2c is electrically connected to the second additional conductive pattern ACP2 located in the different layer, line resistance of the second dummy power line PL2c may be reduced.

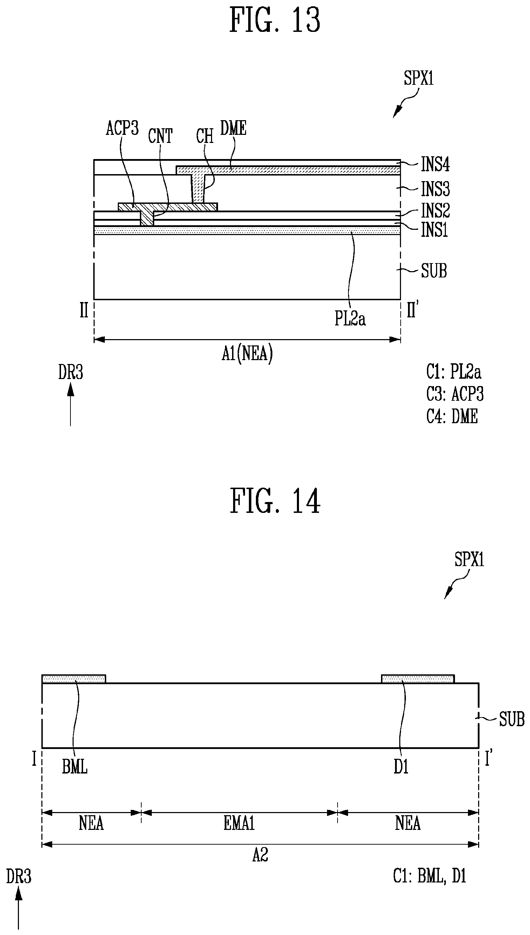

The second vertical power line PL2a may be electrically connected, through a corresponding contactor CNT, to a third additional conductive pattern ACP3 located in a different layer. The third additional conductive pattern ACP3 may be formed of the third conductive layer C3, and may overlap a portion of the second vertical power line PL2a. The third additional conductive electrode ACP3 may be electrically connected to the dummy electrode DME through a corresponding contact hole CH. The dummy electrode DME may be formed of the fourth conductive layer C4, and may overlap a portion of the third additional conductive pattern ACP3 and one area of the second vertical power line PL2a. The dummy electrode DME may be electrically connected to the second vertical power line PL2a through a corresponding contact hole CH. The second vertical power line PL2a may be electrically connected to the third additional conductive pattern ACP3 and the dummy electrode DME that are located in different layers, thus forming a multilayer structure (e.g., see FIG. 13). Hence, line resistance of the second vertical power line PL2a may be reduced.

The initialization power line IPL may extend in the second direction DR2. The initialization power line IPL may be located in each of the first to third sub-pixel areas SPXA1 to SPXA3, and may be located to be spaced from a corresponding data line. The initialization power line IPL may be formed of the first conductive layer C1. The initialization power line IPL may be the j-th sensing line SENj described with reference to FIG. 5. The initialization power line IPL may be supplied with an initialization voltage. The initialization power line IPL in each of the first to third sub-pixels SPX1 to SPX3 may be electrically connected to the third transistor T3 of the pixel circuit PXC through a fourth connection pattern CNP4.

The fourth connection pattern CNP4 may be formed of the fourth conductive layer C4, and may be electrically connected to the initialization power line IPL through a corresponding contact hole CH. The fourth connection pattern CNP4 may be electrically connected to the third transistor T3 of each of the first to third sub-pixels SPX1 to SPX3 through a corresponding contact hole CH.

The initialization power line IPL, the first, second, and third data lines D1, D2, and D3, the first vertical power line PL1a, and the second vertical power line PL2a may be located in both the first area A1 and the second area A2.

Each of the first to third sub-pixels SPX1 to SPX3 may include a pixel circuit PXC. The pixel circuit PXC may include a first transistor T1, a second transistor T2, a third transistor T3, and a storage capacitor Cst.

The pixel circuit PXC of the first sub-pixel SPX1, the pixel circuit PXC of the second sub-pixel SPX2, and the pixel circuit PXC of the third sub-pixel SPX3 may have a substantially identical or similar structure. Hereinafter, the pixel circuit PXC of the first sub-pixel SPX1 will be described as a representative example. The description of the pixel circuit PXC of the first sub-pixel SPX1 will substitute for that of the pixel circuit PXC of the second sub-pixel SPX2 and the pixel circuit PXC of the third sub-pixel SPX3.

The pixel circuit PXC of the first sub-pixel SPX1 may be located in the first area A1 of the first sub-pixel area SPXA1. For example, the first to third transistors T1 to T3 and the storage capacitor Cst may be located in the first area A1 of the first sub-pixel area SPXA1.

The first transistor T1 may include a first gate electrode GE1, a first active pattern ACT1, a first source electrode SE1 (or a first source area), and a first drain electrode DE1 (or a first drain area).

The first gate electrode GE1 may be electrically connected to a first connection pattern CNP1 through a contact hole. The first gate electrode GE1 may be formed of the third conductive layer C3.

The first connection pattern CNP1 may be formed of the fourth conductive layer C4. One end of the first connection pattern CNP1 may be electrically connected to the first gate electrode GE1 through a corresponding contact hole CH. A remaining end of the first connection pattern CNP1 may be electrically connected to the second source electrode SE2 of the second transistor T2 through a corresponding contact hole CH. The first gate electrode GE1 and the second source electrode SE2 may be electrically connected to each other through the first connection pattern CNP1.

The first active pattern ACT1, the first source electrode SE1, and the first drain electrode DE1 are formed of the same intrinsic semiconductor layer SCL. For example, the first active pattern ACT1, the first source electrode SE1, and the first drain electrode DE1 may be configured of an intrinsic semiconductor layer SCL formed of poly silicon, amorphous silicon, an oxide semiconductor, and/or the like. In accordance with the present invention, each of the first source electrode SE1 and the first drain electrode DE1 is an area of the intrinsic semiconductor layer which is doped with impurities to have conductivity, and the first active pattern ACT1 is an area of the intrinsic semiconductor layer which is not doped with impurities.

The first active pattern ACT1 may be located under the first gate electrode GE1 formed of the third conductive layer C3, and may overlap the first gate electrode GE1. The first active pattern ACT1 may form a channel area of the first transistor T1.

The first source electrode SE1 may be connected to one end of the first active pattern ACT1. The first source electrode SE1 may be doped with impurities during an impurity doping process which is performed after the third conductive layer C3 is formed, and may thus have conductivity. The first source electrode SE1 may be electrically connected to a second connection pattern CNP2 through a corresponding contact hole CH.

The second connection pattern CNP2 may be formed of the fourth conductive layer C4. A portion of the second connection pattern CNP2 may be electrically connected to the first source electrode SE1 through a corresponding contact hole CH. Another portion of the second connection pattern CNP2 may be electrically connected to the third source electrode SE3 of the third transistor T3 through a corresponding contact hole CH. Another portion of the second connection pattern CNP2 may be electrically connected to a bottom metal pattern BML through a corresponding contact hole CH. The first source electrode SE1, the third source electrode SE3, and the bottom metal pattern BML (e.g., formed of the first conductive layer C1) may be electrically connected to each other by the second connection pattern CNP2.

The second connection pattern CNP2 may be electrically connected to the emission component EMU of the first sub-pixel SPX1 through a corresponding contact hole CH. For example, the second connection pattern CNP2 may be electrically connected to the first electrode PE1 through a corresponding contact hole CH.

The bottom metal pattern BML may be formed of the first conductive layer C1. The bottom metal pattern BML may be electrically connected to the second connection pattern CNP2 through a corresponding contact hole CH. The bottom metal pattern BML may be electrically connected to the first source electrode SE1 by the second connection pattern CNP2.

The bottom metal pattern BML may extend from the first area A1 to the second area A2. In the first area A1, the bottom metal pattern BML may overlap the first transistor T1. In the second area A2, the bottom metal pattern BML may overlap the storage capacitor Cst. The bottom metal pattern BML may shield the first transistor T1 and the storage capacitor Cst from a lower side thereof.

The bottom metal pattern BML positioned in the second area A2 (or extending into the second area A2) may be electrically connected to the upper electrode UE of the storage capacitor Cst through a corresponding contact hole CH. Hence, the bottom metal pattern BML and the upper electrode UE may be supplied with the same signal. The bottom metal pattern BML positioned in the second area A2 may overlap the lower electrode LE of the storage capacitor Cst so that the capacitance of the storage capacitor Cst may be further increased.

The first drain electrode DE1 may be connected to a remaining end of the first active pattern ACT1. The first drain electrode DE1 may be electrically connected to the first horizontal power line PL1b through a corresponding contact hole CH.

The second transistor T2 may include a second gate electrode GE2, a second active pattern ACT2, a second source electrode SE2, and a second drain electrode DE2.

The second gate electrode GE2 may be electrically connected to the scan line SC through a corresponding contact hole CH. The second gate electrode GE2 may overlap the second active pattern ACT2.

Each of the second active pattern ACT2, the second source electrode SE2 (or a second source area), and the second drain electrode DE2 (or a second drain area) may be formed of the semiconductor layer SCL. For example, the second active pattern ACT2, the second source electrode SE2 (or the second source area), and the second drain electrode DE2 (or the second drain area) may be configured of the semiconductor layer SCL formed of poly silicon, amorphous silicon, an oxide semiconductor, and/or the like. Each of the second source electrode SE2 and the second drain electrode DE2 may be doped with impurities and have conductivity. The second active pattern ACT2 may be formed of an intrinsic semiconductor layer which is not doped with impurities.

The second active pattern ACT2 may be located under the second gate electrode GE2 formed of the third conductive layer C3, and may overlap the second gate electrode GE2. The second active pattern ACT2 may form a channel area of the second transistor T2.

The second source electrode SE2 may be connected to one end of the second active pattern ACT2. The second source electrode SE2 may be doped with impurities during an impurity doping process which is performed after a separate mask is used or the third conductive layer C3 is used as a mask, thus having conductivity. The second source electrode SE2 may be electrically connected to the first connection pattern CNP1 through a corresponding contact hole CH.

The second drain electrode DE2 may be connected to a remaining end of the second active pattern ACT2. The second drain electrode DE2 may be doped with impurities during an impurity doping process which is performed after a separate mask is used or the third conductive layer C3 is used as a mask, thus having conductivity. The second drain electrode DE2 may be electrically connected to a third connection pattern CNP3 through a corresponding contact hole CH.

The third connection pattern CNP3 may be formed of the fourth conductive layer C4. One end of the third connection pattern CNP3 may be electrically connected to the second drain electrode DE2 through a corresponding contact hole CH. A remaining end of the third connection pattern CNP3 may be electrically connected, through a corresponding contact hole CH, to the first data line D1 formed of the first conductive layer C1. The second drain electrode DE2 and the first data line D1 may be electrically connected to each other by the third connection pattern CNP3.

The third transistor T3 may include a third gate electrode GE3, a third active pattern ACT3, a third source electrode SE3, and a third drain electrode DE3.

The third gate electrode GE3 may be electrically connected to the scan line SC through a corresponding contact hole CH. The third gate electrode GE3 may overlap the third active pattern ACT3, and may be formed of the third conductive layer C3.

The third active pattern ACT3, the third source electrode SE3 (or a third source area), and the third drain electrode DE3 (or a third drain area) may be formed of the semiconductor layer SCL. For example, the third active pattern ACT3, the third source electrode SE3, and the third drain electrode DE3 may be configured of a semiconductor pattern formed of poly silicon, amorphous silicon, an oxide semiconductor, and/or the like. Each of the third source electrode SE3 and the third drain electrode DE3 may be doped with impurities and have conductivity. The third active pattern ACT3 may be formed of an intrinsic semiconductor layer which is not doped with impurities.

The third active pattern ACT3 may be located under the third gate electrode GE3 formed of the third conductive layer C3, and may overlap the third gate electrode GE3. The third active pattern ACT3 may form a channel area of the third transistor T3.

The third source electrode SE3 may be connected to one end of the third active pattern ACT3. The third source electrode SE3 may be doped with impurities during an impurity doping process which is performed after a separate mask is used or the third conductive layer C3 is used as a mask, thus having conductivity. The third source electrode SE3 may be electrically connected to a second connection pattern CNP2 through a corresponding contact hole CH.

The third drain electrode DE3 may be connected to a remaining end of the third active pattern ACT3. The third drain electrode DE3 may be doped with impurities after a separate mask is used or the third conductive layer C3 is used as a mask, thus having conductivity. The third drain electrode DE3 may be electrically connected to a fourth connection pattern CNP4 through a corresponding contact hole CH.

The storage capacitor Cst may include a lower electrode LE and an upper electrode UE.

The lower electrode LE may be provided in a shape extending from the second source electrode SE2 to the second area A2. The lower electrode LE may be integrally formed with the second source electrode SE2. The lower electrode LE may be configured of the semiconductor layer SCL. For example, the lower electrode LE may be configured of a semiconductor pattern formed of poly silicon, amorphous silicon, an oxide semiconductor, and/or the like, and may have conductivity after having been doped with impurities.

The upper electrode UE may be formed of the fourth conductive layer C4, and may extend in the second direction DR2 in the second area A2. The upper electrode UE may be located to overlap the lower electrode LE, and may be electrically connected to the bottom metal pattern BML through a corresponding contact hole CH. The upper electrode UE may be electrically connected to the first electrode PE1 of the emission component EMU by the second connection pattern CNP2 that is electrically connected to the bottom metal pattern BML.

The emission component EMU of each of the first to third sub-pixels SPX1 to SPX3 may include light-emitting elements LD located in the second area A2 of the corresponding sub-pixel. Furthermore, the emission component EMU may include an electrode PE (or a pixel electrode) electrically connected to the light-emitting elements LD, and alignment electrodes ALE overlapping the light-emitting elements LD. A first bank BNK1 may be located in a non-emission area NEA of each of the first to third sub-pixels SPX1 to SPX3.

The first bank BNK1 may be a structure defining the first emission area EMA1, the second emission area EMA2, and the third emission area EMA3, and may be a pixel defining layer. For example, the first bank BNK1 may be a structure defining the emission area of each of adjacent sub-pixels. The first bank BNK1 may define a supply position of light-emitting elements LD during a process of supplying (or inputting) the light-emitting elements LD to each of the first to third sub-pixels SPX1 to SPX3. For example, because the first to third emission areas EMA1 to EMA3 are partitioned (or defined) by the first bank BNK1, a mixed solution (e.g., ink) including a target amount and/or type of light-emitting elements LD may be supplied (or inputted) to a corresponding emission area.

The first bank BNK1 may include at least one light block material and/or reflective material (or scattering material), thus preventing a light leakage defect in which light (or rays) leaks between adjacent sub-pixels. The first bank BNK1 may include transparent material (or substance). The transparent material may include, for example, polyamides resin, polyimides resin, and/or the like, but it is not limited thereto. To enhance the efficiency of light emitted from each of the first to third sub-pixels SPX1, SPX2, and SPX3, a separate reflective material layer may be provided and/or formed on the first bank BNK1.

The first bank BNK1 may include, in the pixel area PXA, an opening OP through which components located thereunder are exposed. Each of the first to third emission areas EMA1 to EMA3 may correspond to the opening OP of the first bank BNK1.

The first bank BNK1 may be located in the non-emission area NEA between the first to third emission areas EMA1 to EMA3. Hence, a supply (or input) area of the light-emitting elements LD in the pixel area PXA may be determined. In this case, at the step of supplying light-emitting elements LD to the pixel PXL, the light-emitting elements LD may be prevented from being supplied to undesired areas, and the light-emitting elements LD may be efficiently supplied to each of the first to third emission areas EMA1 to EMA3. Hence, the light-emitting elements LD may be prevented from being unnecessarily wasted. The manufacturing cost of the display device DD (or the pixel PXL) may be reduced.

In a plan view, the first bank BNK1 may be provided in a shape enclosing the light-emitting elements LD. The first bank BNK1 may overlap at least some of the alignment electrodes ALE.

The emission component EMU of the first sub-pixel SPX1, the emission component EMU of the second sub-pixel SPX2, and the emission component EMU of the third sub-pixel SPX3 may have a substantially identical or similar structure. Hereinafter, the emission component EMU of the first sub-pixel SPX1 will be described as a representative example. The description of the emission component EMU of the first sub-pixel SPX1 will substitute for that of the emission component EMU of the second sub-pixel SPX2 and the emission component EMU of the third sub-pixel SPX3.

The emission component EMU of the first sub-pixel SPX1 may include an electrode PE located in at least the first emission area EMA1, light-emitting elements LD electrically connected to the electrode PE, and an alignment electrode ALE provided at a position corresponding to the electrode PE. For example, the emission component EMU may include a first electrode PE1 (or a first pixel electrode), a second electrode PE2 (or a second pixel electrode), the light-emitting elements LD, and first and second alignment electrodes ALE1 and ALE2 that are located in at least the first emission area EMA1. The number, shape, size, arrangement structure, and/or the like of each of the electrodes PE and/or the alignment electrodes ALE may be changed in various ways depending on the structure of the first sub-pixel SPX1.

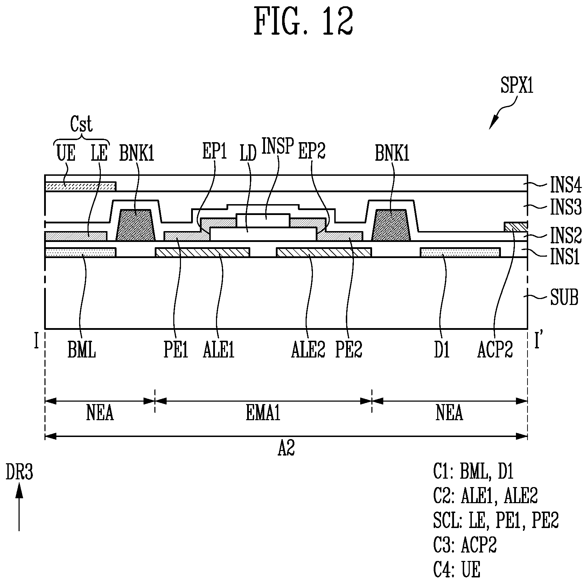

Based on one surface of the substrate SUB on which the first sub-pixel SPX1 is located, the alignment electrodes ALE, the light-emitting elements LD, and the electrodes PE may be provided in the order listed. Description of a stacked structure (or a cross-sectional structure) of the first sub-pixel SPX1 will be made below with reference to FIGS. 12 and 13.

The alignment electrodes ALE may be located in at least the first emission area EMA1, and may be spaced from each other with respect to the first direction DR1 in the first emission area EMA1, and each may extend in the second direction DR2. The alignment electrodes ALE may include the first alignment electrode ALE1 and the second alignment electrode ALE2 that are spaced from each other in the first direction DR1.

The first and second alignment electrodes ALE1 and ALE2 may be formed by removing portions of the alignment lines after the light-emitting elements LD are aligned in the first emission area EMA1 during the process of fabricating the display device DD (or the pixel PXL). As illustrated in FIG. 9B, before the alignment of the light-emitting elements LD, the first alignment electrode ALE1 may be one area of a first alignment line ALL1 a portion of which has not been removed, and the second alignment electrode ALE2 may be one area of a second alignment line ALL2 a portion of which has not been removed.

The first alignment line ALL1 and the second alignment line ALL2 are formed in the pixel area PXA. A first alignment signal may be applied to the first alignment line ALL1 through a first alignment pad. A second alignment signal may be applied to the second alignment line ALL2 through a second alignment pad. The first and second alignment signals may be signals having a voltage difference and/or a phase difference enabling the light-emitting elements LD to be aligned between the first alignment line ALL1 and the second alignment line ALL2. After the light-emitting elements LD are aligned, the first alignment electrode ALE1 may be formed by removing a portion of the first alignment line ALL1, and the second alignment electrode ALE2 may be formed by removing a portion of the second alignment line ALL2.

The first alignment electrode ALE1 and the second alignment electrode ALE2 may be formed of the second conductive layer C2. The first alignment electrode ALE1 and the second alignment electrode ALE2 may be substantially positioned in the second area A2. The second conductive layer C2 may include the same material as that of the fourth conductive layer C4, or may include one or more suitable (or selected) materials from among materials exemplified as the constituent material of the fourth conductive layer C4, but it is not limited thereto.

Each of the first alignment electrode ALE1 and the second alignment electrode ALE2 may be provided in the form of a bar having a constant width in the first emission area EMA1, but they are not limited thereto.

Each of the first and second alignment electrodes ALE1 and ALE2 may float rather than being connected to any electrode. In this case, during a process of driving the light-emitting elements LD, an electrical effect of the first and second alignment electrodes ALE1 and ALE2 on the first and second electrodes PE1 and PE2 may be reduced or prevented.

The light-emitting elements LD may be aligned and/or provided in the first emission area EMA1 (or the first sub-pixel SPXA1).

The light-emitting elements LD may be located between the first alignment electrode ALE1 and the second electrode ALE2. In a plan view, each of the light-emitting elements LD may include a first end EP1 and a second end EP2 which are positioned (or oppose each other) on respective opposite ends of the light-emitting element LD in the longitudinal direction thereof, e.g., in the first direction DR1. The second semiconductor layer (refer to "13" of FIG. 1) including a p-type semiconductor layer may be located on the first end EP1 (or the p-type end), and the first semiconductor layer (refer to "11" of FIG. 1) including an n-type semiconductor layer may be located on the second end EP2 (or the n-type end). The light-emitting elements LD may be electrically connected in parallel to each other between the first alignment electrode ALE1 and the second alignment electrode ALE2.

The light-emitting elements LD may be located at positions spaced from each other and aligned substantially in parallel to each other. A distance by which the light-emitting elements LD are spaced from each other is not particularly limited. A plurality of light-emitting elements LD may be located adjacent to each other to form a group, and a plurality of additional light-emitting elements LD may be spaced from each other at regular intervals to form a group. The light-emitting elements LD may be aligned in one direction with an uneven density.

The light-emitting elements LD may be inputted (or supplied) to the first emission area EMA1 (or the opening OP of the first bank BNK1) by an inkjet printing scheme, a slit coating scheme, and/or other various schemes. For example, the light-emitting elements LD may be mixed with a volatile solvent and then inputted (or supplied) to the first emission area EMA1 by an inkjet printing scheme or a slit coating scheme.

The first end EP1 of each of the light-emitting elements LD may be electrically connected to the first electrode PE1. The second end EP2 of each of the light-emitting elements LD may be electrically connected to the second electrode PE2. The light-emitting elements LD may be connected in parallel between the first electrode PE1 and the second electrode PE2.

The electrodes PE may be provided in at least the first emission area EMA1, and each may be provided at positions corresponding to at least one alignment electrode ALE and the light-emitting elements LD. For example, each of the electrodes PE may be formed on the corresponding alignment electrode ALE and the light-emitting elements LD to overlap the corresponding alignment electrode ALE and the light-emitting elements LD, and thus electrically connected to at least the light-emitting elements LD.

The electrodes PE may include the first electrode PE1 and the second electrode PE2 that are spaced from each other.

The first electrode PE1 (referred to as "first pixel electrode" or "anode") may be formed on one side of the first alignment electrode ALE1 and the respective first ends EP1 of the light-emitting elements LD, and thus electrically connected to the respective first ends EP1 of the light-emitting elements LD. The first electrode PE1 may have a bar shape having a constant width in an extension direction thereof, e.g., the second direction DR2.

The second electrode PE2 (referred also to as "second pixel electrode" or "cathode") may be formed on the second alignment electrode ALE2 and the respective second ends EP2 of the light-emitting elements LD, and thus electrically connected to the respective second ends EP2 of the light-emitting elements LD. The second electrode PE2 may have a bar shape having a constant width in an extension direction thereof, e.g., the second direction DR2.

The first electrode PE1 and the second electrode PE2 may be located to be spaced from each other in the first emission area EMA1. The first electrode PE1 and the second electrode PE2 may be formed of the semiconductor layer SCL. For example, the first electrode PE1 and the second electrode PE2 may be configured of the semiconductor layer SCL formed of poly silicon, amorphous silicon, an oxide semiconductor, and/or the like. The first electrode PE1 and the second electrode PE2 may be doped with impurities during an impurity doping process which is performed after a separate mask is used or the third conductive layer C3 is used as a mask, thus having conductivity.

The first and second electrodes PE1 and PE2 may be provided in the same layer as the first to third active patterns ACT1 to ACT3, the first to third source electrodes SE1 to SE3, the first to third drain electrodes DE1 to DE3, and the lower electrode LE. For instance, the first and second electrodes PE1 and PE2 may be formed through the same process as the first to third active patterns ACT1 to ACT3, the first to third source electrodes SE1 to SE3, the first to third drain electrodes DE1 to DE3, and the lower electrode LE, and may be provided in the same layer.

The first electrode PE1 may extend to the first area A1 and may be electrically connected to a second connection pattern CNP2 through a corresponding contact hole CH. The contact hole CH may be formed by opening a portion of at least one insulating layer located between the first electrode PE1 configured of the semiconductor layer SCL and the second connection pattern CNP2 configured of the fourth conductive layer C4. A portion of the first electrode PE1 may be exposed through the contact hole CH.

The second electrode PE2 may be electrically connected to the second horizontal power line PL2b through a corresponding contact hole CH. The contact hole CH may be formed by opening a portion of at least one insulating layer located between the second electrode PE2 configured of the semiconductor layer SCL and the second horizontal power line PL2b configured of the fourth conductive layer C4. A portion of the second electrode PE2 may be exposed through the contact hole CH.

The first electrode PE1 may be an anode of the emission component EMU of the first sub-pixel SPX1. The second electrode PE2 may be a cathode of the emission component EMU.

Hereinafter, the stacked structure (or the cross-sectional structure) of the first sub-pixel SPX1 in accordance with the foregoing will be mainly described with reference to FIGS. 12 and 13.

FIG. 12 is a schematic cross-sectional view taken along the line I-I' of FIG. 7. FIG. 13 is a schematic cross-sectional view taken along line II-II' of FIG. 7.

Although FIGS. 12 and 13 simply illustrate the stacked structure of the first sub-pixel SPX1, e.g., illustrating that each electrode is formed of an electrode having a single layer, and each insulating layer is formed of a single insulating layer, the structure is not limited thereto.

Referring to FIGS. 7 - 13, the first sub-pixel SPX1 may be located in a first sub-pixel area SPXA1 provided in the substrate SUB. The first sub-pixel area SPXA1 may include a first area A1 and a second area A2.

Circuit elements for forming the pixel circuit PXC of the first sub-pixel SPX1, and signal lines electrically connected to the circuit elements may be located in the first area A1.

The light-emitting-element layer (refer to "LDL" of FIG. 4) that forms the emission component EMU of the first sub-pixel SPX1 may be located in the second area A2. Furthermore, the signal lines extending to the first area A1 may be located in the second area A2. The second area A2 may include the first emission area EMA1 from which light may be emitted.

At least one or more insulating layers may be located on the substrate SUB. For example, a first insulating layer INS1, a second insulating layer INS2, a third insulating layer INS3, and a fourth insulating layer INS4 which are successively stacked in the third direction DR3 (e.g., a thickness direction of the substrate SUB) may be located on the substrate SUB. At least one or more conductive layers may be located on the substrate SUB. For example, the conductive layer may include a first conductive layer C1 and a second conductive layer C2 that are located on the substrate SUB, a third conductive layer C3 located on the second insulating layer INS2, and a fourth conductive layer C4 located on the third insulating layer INS3. The semiconductor layer SCL may be located on the first insulating layer INS1.

The first conductive layer C1 (or a bottom metal layer) may include the first vertical power line PL1a, the second vertical power line PL2a, the initialization power line IPL, the first to third data lines D1 to D3, and the bottom metal pattern BML.

The second conductive layer C2 (or an alignment electrode conductive layer) may include the first alignment electrode ALE1 and the second alignment electrode ALE2.

The third conductive layer C3 (or a gate conductive layer) may include the first to third gate electrodes GE1 to GE3, and the first to third additional conductive patterns ACP1 to ACP3.

The fourth conductive layer C4 (or a source-drain conductive layer) may include the first horizontal power line PL1b, the first dummy power line PL1c, the second horizontal power line PL2b, the second dummy power line PL2c, the first to fourth connection patterns CNP1, CNP2, CNP3, and CNP4, the upper electrode UE, the dummy electrode DME, and the scan line SC. The semiconductor layer SCL may include the first to third active patterns ACT1 to ACT3, the first to third source electrodes SE1 to SE3, the first to third drain electrodes DE1 to DE3, the lower electrode LE, the first electrode PE1, and the second electrode PE2.

The substrate SUB may include transparent insulating material to allow light transmission. The substrate SUB may be a rigid substrate and/or a flexible substrate.

The first insulating layer INS1 (or a buffer layer) may be located on the overall surface of the substrate SUB and the first and second conductive layers C1 and C2. The first insulating layer INS1 may prevent impurities from diffusing into the first to third transistors T1 to T3 included in the pixel circuit PXC. The first insulating layer INS1 may be an inorganic insulating layer including inorganic material. The first insulating layer INS1 may include at least one of silicon nitride (SiNₓ), silicon oxide (SiOₓ), silicon oxynitride (SiOₓN_{y}), and/or at least one of metal oxides such as aluminum oxide (AlOₓ). Although the first insulating layer INS1 may have a single-layer structure, the first insulating layer INS1 may have a multilayer structure having at least two or more layers. In the case in which the first buffer layer (e.g., the first insulating layer INS1) has a multilayer structure, the respective layers may be formed of the same material and/or different materials. The first insulating layer INS1 may be omitted depending on the material of the substrate SUB or processing conditions.

The second insulating layer INS2 (or a gate insulating layer) may be located on the first insulating layer INS1 and the semiconductor layer SCL. The second insulating layer INS2 may include the same material as the first insulating layer INS1, or may include suitable (or selected) materials from among materials exemplified as the constituent material of the first insulating layer INS1. For example, the second insulating layer INS2 may include an inorganic insulating layer including inorganic material. The second insulating layer INS2 may be partially located on the first insulating layer INS1. For example, the second insulating layer INS2 may be etched along with base material of the third conductive layer C3 during a process of fabricating the third conductive layer C3 so that the second insulating layer INS2 is located only under the third conductive layer C3.

The third insulating layer INS3 (or an interlayer insulating layer) may be provided and/or formed on the overall surfaces of the second insulating layer INS2 and the third conductive layer C3. The third insulating layer INS3 may include the same material as the first insulating layer INS1, or may include one or more suitable (or selected) materials from among materials exemplified as the constituent material of the first insulating layer INS1. For example, the third insulating layer INS3 may be formed of an inorganic insulating layer including inorganic material.

The fourth insulating layer INS4 (or a passivation layer) may be provided and/or formed on the overall surface of the third insulating layer INS3. The fourth insulating layer INS4 may include the same material as the first insulating layer INS1, or may include one or more suitable (or selected) materials from among materials exemplified as the constituent material of the first insulating layer INS1. For example, the fourth insulating layer INS4 may be an inorganic insulating layer including inorganic material, but it is not limited thereto. The fourth insulating layer INS4 may be formed of an organic insulating layer including organic material.

The pixel circuit PXC may include first to third transistors T1 to T3, and a storage capacitor Cst which are located on the first insulating layer INS1. The first to third transistors T1 to T3 may be located in the first area A1. The storage capacitor Cst may be located in the second area A2.

The first transistor T1 may include a first active pattern ACT1, a first source electrode SE1, and a first drain electrode DE1 which are located on the first insulating layer INS1, and a first gate electrode GE1 located on the second insulating layer INS2. The bottom metal pattern BML may be located under the first transistor T1 on the substrate SUB.

The second transistor T2 may include a second active pattern ACT2, a second source electrode SE2, and a second drain electrode DE2 which are located on the first insulating layer INS1, and a second gate electrode GE2 located on the second insulating layer INS2.

The third transistor T3 may include a third active pattern ACT3, a third source electrode SE3, and a third drain electrode DE3 which are located on the first insulating layer INS1, and a third gate electrode GE3 located on the second insulating layer INS2.

The storage capacitor Cst may include a lower electrode LE located on the first insulating layer INS1, and an upper electrode UE located on the third insulating layer INS3. The lower electrode LE may be integrally formed with the second source electrode SE2 and thus connected to the second source electrode SE2, and may have conductivity. The upper electrode UE may be formed of the fourth conductive layer C4, and may be electrically connected to the bottom metal pattern BML through a corresponding contact hole CH that passes through the third insulating layer INS3, the second insulating layer INS2, and the first insulating layer INS1.

The fourth insulating layer INS4 may be provided and/or formed on the pixel circuit PXC.

The emission component EMU may include the first and second alignment electrodes ALE1 and ALE2 located on the substrate SUB, the light-emitting elements LD located on the first insulating layer INS1, the first electrode PE1 located on the first ends EP1 of the light-emitting elements LD, and the second electrode PE2 located on the second ends EP2 of the light-emitting elements LD.

The first alignment electrode ALE1 and the second alignment electrode ALE2 may be configured of the second conductive layer C2, and located on the substrate SUB at a position spaced from the first conductive layer C1. After the first conductive layer C1 is formed, the first alignment electrode ALE1 and the second alignment electrode ALE2 may be formed through a successive process with a spacing distance from the first conductive layer C1. In this case, the first and second alignment electrodes ALE1 and ALE2 may be located in the same layer as components of the first conductive layer C1. In accordance with the present invention, the first and second alignment electrodes ALE1 and ALE2 are provided in the same layer as the bottom metal pattern BML. According to an example not forming part of the present invention, the first and second alignment electrodes ALE1 and ALE2 may be formed after a process of forming an additional insulating layer on the first conductive layer C1 to more reliably ensure electrical separation from the first conductive layer C1 is performed. In this case, the first and second alignment electrodes ALE1 and ALE2 may be located in a layer different from components of the first conductive layer C1.

The first and second alignment electrodes ALE1 and ALE2 may be formed of material having a reflectivity to allow light emitted from the light-emitting elements LD to travel in an image display direction (or a frontal direction or the third direction DR3) of the display device DD. For example, the first and second alignment electrodes ALE1 and ALE2 may be formed of conductive material (or substance). The conductive material may include opaque metal that is suitable for reflecting, in the image display direction (e.g., the third direction DR3) of the display device DD, light emitted from the light-emitting elements LD.

Each of the first and second alignment electrodes ALE1 and ALE2 may have a single-layer structure, but is not limited thereto. Each of the first and second alignment electrodes ALE1 and ALE2 may be provided and/or formed in a multilayer structure formed by stacking at least two or more materials from among metals, alloys, conductive oxides, and conductive polymers.

In the case in which the first and second alignment electrodes ALE1 and ALE2 are formed of conductive material having reflectance, light emitted from the first and second ends EP1 and EP2 of each of the light-emitting elements LD may more reliably travel in the image display direction (e.g., the third direction DR3) of the display device DD.

The first insulating layer INS1 may be located on the first and second alignment electrodes ALE1 and ALE2.

The first bank BNK1 may be located on the first insulating layer INS1 substantially in the non-emission area NEA of the second area A2. However, a portion of the first bank BNK1 may be located in the first to third emission areas EMA1, EMA2, and EMA3 (e.g., see, FIGS. 9A-9B).

The first bank BNK1 may be located on the first insulating layer INS1 in at least the second area A2, but the present disclosure is not limited thereto. The first bank BNK1 may be formed, to enclose the first emission area EMA1, between adjacent sub-pixels so that a pixel defining layer for partitioning (or defining) the first emission area EMA1 may be formed. At the operation of supplying the light-emitting elements LD to the first emission area EMA1, the first bank BNK1 may be a dam structure configured to prevent a solution (or ink) mixed with the light-emitting elements LD from being drawn into the second and third emission areas (refer to "EMA2" and "EMA3" of FIG. 6) or control the amount of solution such that a constant amount of solution is supplied to each of the first to third emission areas EMA1, EMA2, and EMA3.

In the second area A2, the light-emitting elements LD may be aligned (or located) in the first emission area EMA1 in which the first insulating layer INS1 and the first bank BNK1 are formed. For example, the light-emitting elements LD may be supplied (or inputted) to the first emission area EMA1 through an inkjet printing scheme and/or the like. The light-emitting elements LD may be aligned between the first alignment electrode ALE1 and the second alignment electrode ALE2 by an electric field formed by alignment signals that are respectively applied to the first and second alignment electrodes ALE1 and ALE2. For example, the light-emitting elements LD may be aligned on the first insulating layer INS1 between the first alignment electrode ALE1 and the second alignment electrode ALE2.

Each of the light-emitting elements LD may be aligned between the first alignment electrode ALE1 and the second alignment electrode ALE2, and may include the first end EP1 overlapping the first alignment electrode ALE1, and the second end EP2 overlapping the second alignment electrode ALE2.

The insulating pattern INSP may be located on the light-emitting elements LD. The insulating pattern INSP may be located on the light-emitting elements LD to partially cover the outer surface (e.g., the outer peripheral or circumferential surface or the surface)) of each of the light-emitting elements LD such that the first end EP1 and the second end EP2 of each of the light-emitting elements LD are exposed to the outside.

The insulating pattern INSP may include an inorganic insulating layer including inorganic material, and/or an organic insulating layer. For example, the insulating pattern INSP may include an inorganic insulating layer suitable for protecting the active layer 12 of each of the light-emitting elements LD from external oxygen, water, etc. However, it is not limited thereto. The insulating pattern INSP may be formed of an organic insulating layer including organic material, depending on design conditions, and/or the like of the display device DD (or the display panel DP) to which the light-emitting elements LD are applied. The insulating pattern INSP may be formed of a single layer or multiple layers.

Because the insulating pattern INSP is formed on the light-emitting elements LD that have been completely aligned in the first emission area EMA1, the light-emitting elements LD may be prevented from being removed from the aligned positions.

The first electrode PE1 and the second electrode PE2 may be formed on the first and second ends EP1 and EP2 of the light-emitting elements LD that are not covered with the insulating pattern INSP. For example, the first electrode PE1 may be formed on the first ends EP1 of the light-emitting elements LD. The second electrode PE2 may be formed on the second ends EP2 of the light-emitting elements LD.

The first electrode PE1 and the second electrode PE2 may be formed in the same layer. The first electrode PE1 and the second electrode PE2 may be concurrently (e.g., simultaneously) formed with an insulating pattern INSP interposed therebetween. For example, the first electrode PE1 may be located adjacent to a first side surface (e.g., a left side surface) of the insulating pattern INSP of each of the light-emitting elements LD, and the second electrode PE2 may be located adjacent to a second side surface (e.g., a right side surface) of the insulating pattern INSP of each of the light-emitting elements LD. The first electrode PE1 may directly contact the first end EP1 of each of the light-emitting elements LD and may be electrically connected to the light-emitting elements LD. The second electrode PE2 may directly contact the second end EP2 of the light-emitting element LD and may be electrically connected to the light-emitting elements LD. As described above, in the case where the first electrode PE1 and the second electrode PE2 are located in the same layer and are concurrently (e.g., simultaneously) formed, a process of fabricating the first sub-pixel SPX1 (or the display device DD) may be facilitated, and the fabrication efficiency thereof may be enhanced.

Each of the first electrode PE1 and the second electrode PE2 may be formed of various transparent conductive materials. For example, each of the first electrode PE1 and the second electrode PE2 may include at least one of various transparent conductive materials including indium tin oxide, indium zinc oxide, indium tin zinc oxide, aluminum zinc oxide, gallium zinc oxide, zinc tin oxide, and/or gallium tin oxide, and may be substantially transparent or translucent to provide satisfactory transmittance. Hence, light emitted from the first and second ends EP1 and EP2 of the light-emitting elements LD may pass through the first and second electrodes PE1 and PE2 and then may be emitted out of the display device DD (or the display panel DP).

The second insulating layer INS2, the third insulating layer INS3, and the fourth insulating layer INS4 may be located on the first and second electrodes PE1 and PE2.

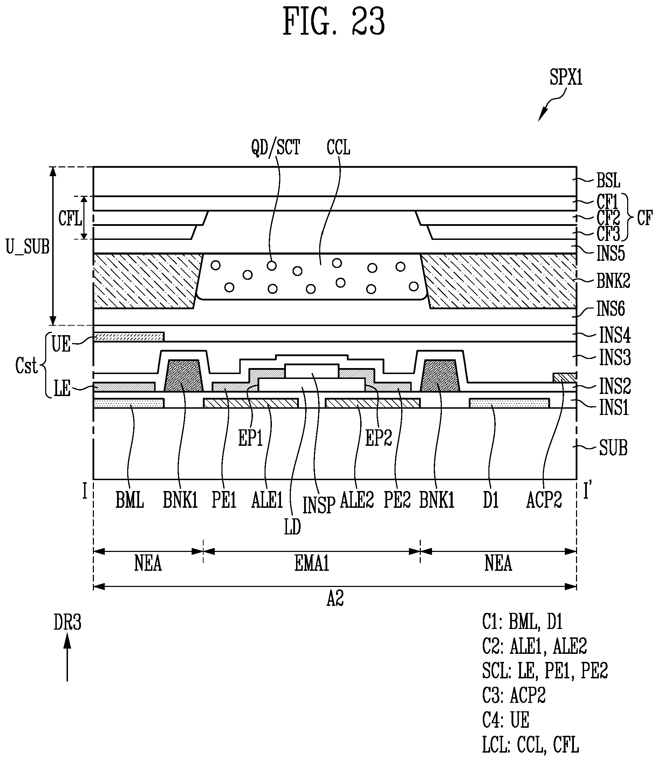

An optical layer (refer to "LCL" of FIG. 4) may be selectively located on the first and second electrodes PE1 and PE2. For example, the optical layer LCL may include a color conversion layer and/or a color filter layer that may convert light emitted from the light-emitting elements LD into light having excellent color reproducibility and emit the converted light. Detailed descriptions pertaining to the optical layer LCL will be made with reference to FIG. 23.

As described above, each of the pixel circuit PXC and the emission component EMU may be provided in a multilayer structure including at least one or more conductive layers and at least one or more insulating layers that are provided and/or formed on one surface of the substrate SUB. At least one layer of the pixel circuit layer PCL and at least one layer of the display element component DPL may be provided in the same layer, may have the same material, and/or may be formed through the same process. For instance, the first and second electrodes PE1 and PE2 of the emission component EMU may be provided in the same layer as the first to third active patterns ACT1 to ACT3, the first to third source electrodes SE1 to SE3, the first to third drain electrodes DE1 to DE3, and the lower electrode LE of the pixel circuit PXC, may include the same material, and/or may be formed through the same process.

According to the foregoing, the components included in the pixel circuit PXC and the components included in the emission component EMU are formed through the same process. Therefore, the number of masks may be reduced compared to that of the existing display device in which the pixel circuit PXC and the emission component EMU are formed through respective separate processes. Consequently, a display device DD with improved fabrication efficiency may be provided.

According to the foregoing, the light-emitting elements LD are intensively aligned in a desired area, e.g., the second area A2 of each of the first to third sub-pixels SPX1, SPX2, and SPX3, so that alignment distribution of the light-emitting elements LD in each sub-pixel and alignment distribution of the light-emitting elements LD in adjacent sub-pixels may be uniform. In this case, the display device DD may have uniform light output distribution in the overall area thereof, whereby the reliability thereof may be enhanced.

In accordance with the aforementioned, in the case where the light-emitting elements LD are intensively aligned in a desired area, the number of misaligned light-emitting elements LD may be reduced. Accordingly, the loss of the light-emitting elements LD may be reduced or minimized, so that abnormal alignment defects in which the light-emitting elements LD are aligned in undesired areas may be prevented or reduced from occurring.

In accordance with the aforementioned, the emission component EMU including the light-emitting elements LD and the pixel circuit PXC including the circuit elements (e.g., the first to third transistors T1 to T3 and the storage capacitor Cst) may be located on the same substrate. Consequently, a display device DD that is more advantageous for implementing a slim structure may be provided, compared to the existing display device including a sub-pixel in which the emission component is positioned over the pixel circuit such that the pixel circuit and the emission component overlap each other.

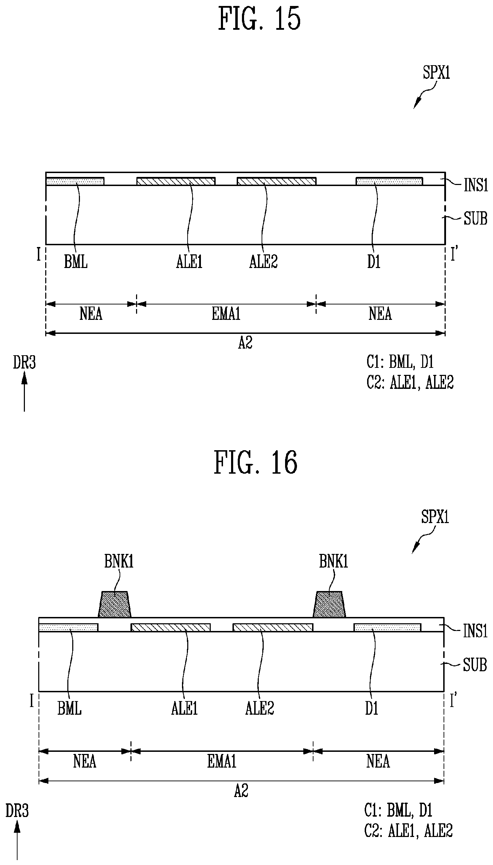

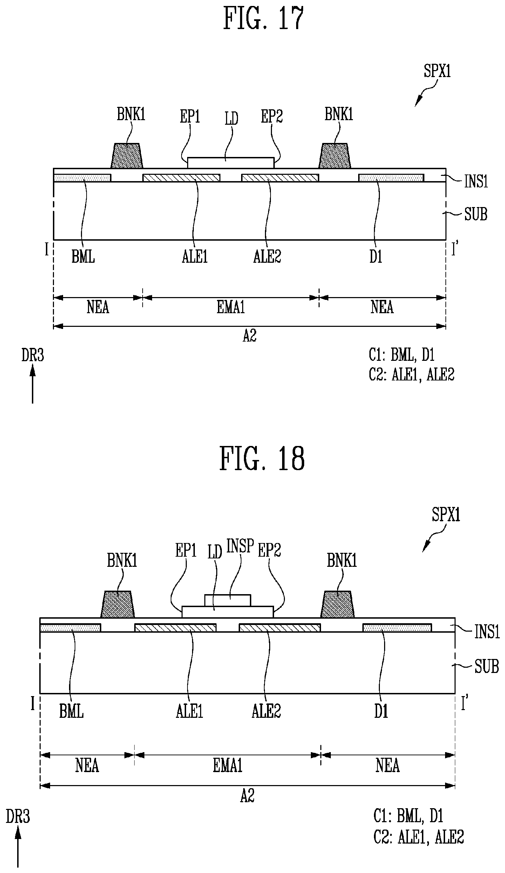

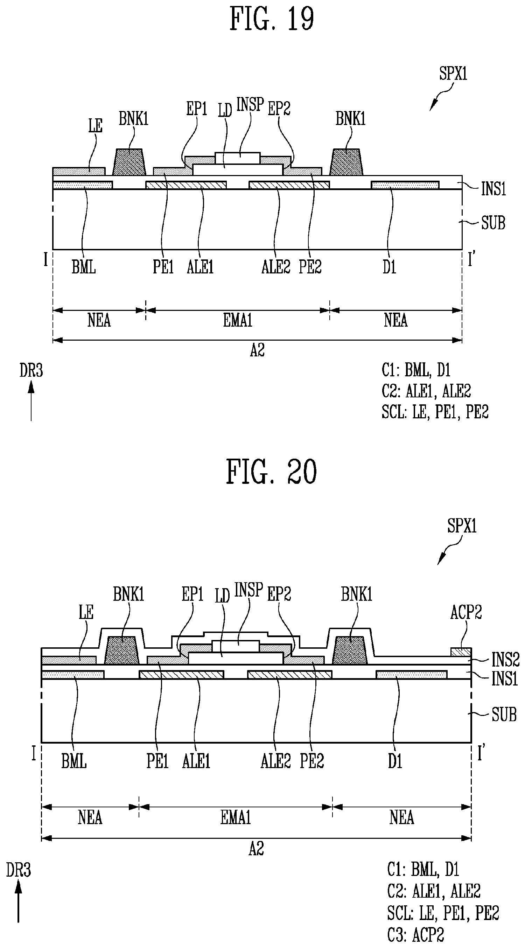

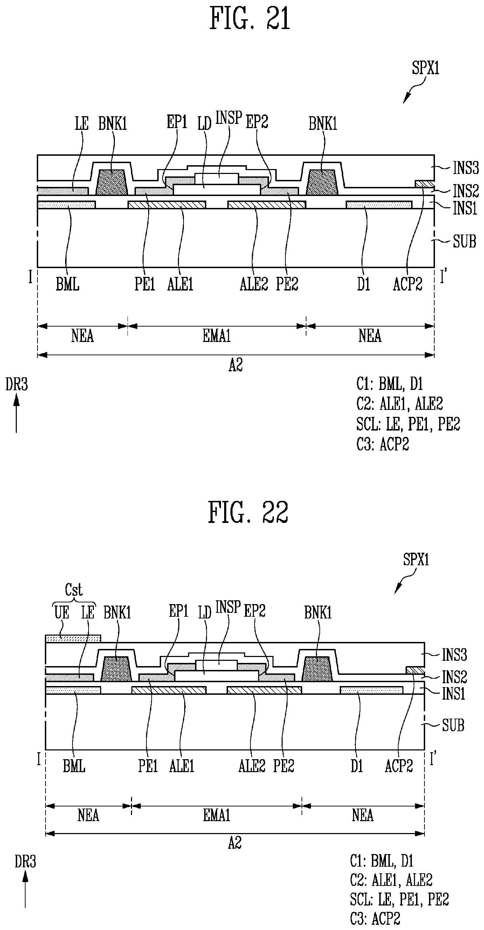

FIGS. 14 - 22 are diagrams for describing a method of fabricating the first sub-pixel SPX1, and are schematic cross-sectional views corresponding to the line I-I' of FIG. 7.

Hereinafter, the method of fabricating the first sub-pixel SPX1 (or the display device) will be sequentially described with reference to FIGS. 14 - 22.

There is illustrated the case where the operations of fabricating the first sub-pixel (or the display device) are sequentially performed according to the sectional views, but without changing the technical scope of the present disclosure, some operations illustrated as being successively performed may be concurrently (e.g., simultaneously) performed, the sequence of the operations may be changed, some operations may be skipped, or an additional operation may be further included between the operations.

The description with reference to FIGS. 14 - 22 will be focused on differences from the above-mentioned examples so as to avoid redundant description.

Referring to FIGS. 7 - 14, the first conductive layer C1 is formed on the substrate SUB. The first conductive layer C1 may include the first vertical power line PL1a, the second vertical power line PL2a, the initialization power line IPL, the first to third data lines D1 to D3, and the bottom metal pattern BML. The first conductive layer C1 may be located in the first area A1 and the second area A2.

Referring to FIGS. 7 - 15, the second conductive layer C2 is formed on the substrate SUB. The second conductive layer C2 may be formed through a successive process after the first conductive layer C1 is formed, and may be located on the substrate SUB at a position spaced from the first conductive layer C1. The second conductive layer C2 may include the first alignment line (refer to "ALL1" of FIG. 9B) (or the first alignment electrode ALE1) and the second alignment line (refer to "ALL2" of FIG. 9B) (or the second alignment electrode ALE2). The first alignment line ALL1 may be integrally formed with the first alignment pad positioned in the non-display area (refer to "NDA" of FIG. 3). The second alignment line ALL2 may be integrally formed with the second alignment pad positioned in the non-display area NDA.

The first insulating layer INS1 may be formed on the overall surfaces of the substrate SUB, the first conductive layer C1, and the second conductive layer C2. The first insulating layer INS1 may be located on the substrate SUB, the first conductive layer C1, and the second conductive layer C2 in the first area A1 and the second area A2. The first insulating layer INS1 may include an inorganic insulating layer including inorganic material. For example, the first insulating layer INS1 may include an inorganic insulating layer including a first layer formed of silicon nitride (SiNₓ) and a second layer formed of silicon oxide (SiOₓ).

Referring to FIGS. 1 - 16, the first bank BNK1 is formed on the first insulating layer INS1 in the second area A2. The first bank BNK1 may define the first emission area EMA1 of the first sub-pixel SPX1. The first bank BNK1 may be located in substantially the non-emission area NEA of each sub-pixel.

Referring to FIGS. 1 - 17, the first alignment line ALL1 electrically connected to the first alignment pad and the second alignment line ALL2 electrically connected to the second alignment pad are respectively supplied with corresponding alignment signals so that an electric field is formed between the first alignment line ALL1 and the second alignment line ALL2.

Ink including light-emitting elements LD is inputted to the second area A2 through an inkjet printing scheme and/or the like. For example, at least one inkjet nozzle may be located over the first insulating layer INS1 in the first bank BNK1 including an opening OP in the second area A2, and ink mixed with a plurality of light-emitting elements LD may be inputted to the second area A2 through the inkjet nozzle. Self-alignment of the light-emitting elements LD may be induced on the first insulating layer INS1 between the first alignment line ALL1 and the second alignment line ALL2.

After the light-emitting elements LD are self-aligned, a solvent included in the ink may be removed by a volatilization scheme and/or other schemes.

Referring to FIGS. 7 - 18, the insulating pattern INSP is formed on the light-emitting elements LD. The insulating pattern INSP allows the first end EP1 and the second end EP2 of each of the light-emitting elements LD to be exposed.

After the insulating pattern INSP is formed, the first and second alignment electrodes ALE1 and ALE2 may be formed by removing respective portions of the first and second alignment lines ALL1 and ALL2 in the first area A1. The first and second alignment electrodes ALE1 and ALE2 may be positioned in only the second area A2. Consequently, the first and second alignment electrodes ALE1 and ALE2 provided in the first sub-pixel SPX1 may be electrically and physically separated from the first and second alignment electrodes ALE1 and ALE2 of adjacent sub-pixels arranged in the same pixel column in the second direction DR2.

Referring to FIGS. 7 - 19, the semiconductor layer SCL is formed on the first insulating layer INS1 and the light-emitting elements LD. The semiconductor layer SCL may include the first to third active patterns ACT1 to ACT3, the first to third source electrodes SE1 to SE3, the first to third drain electrodes DE1 to DE3, the lower electrode LE, and the first and second electrodes PE1 and PE2. The first to third active patterns ACT1 to ACT3, the first to third source electrodes SE1 to SE3, and the first to third drain electrodes DE1 to DE3 may be positioned in the first area A1. The lower electrode LE, the first electrode PE1, and the second electrode PE2 may be positioned in the second area A2.

Each of the first to third active patterns ACT1 to ACT3 may be an intrinsic semiconductor that is not doped with impurities. The first to third source electrodes SE1 to SE3, the first to third drain electrodes DE1 to DE3, the lower electrode LE, and the first and second electrodes PE1 and PE2 may be doped with impurities to have conductivity, and thus may be used as conductive patterns.

After the semiconductor layer SCL including at least one of poly silicon, amorphous silicon, and/or an oxide semiconductor is formed on the first insulating layer INS1 and the light-emitting element LD, a separate mask is located over positions at which the first to third active patterns ACT1 to ACT3 are to be formed, and then the semiconductor layer SCL is doped with impurities. Areas of the semiconductor layer SCL that is doped with impurities to have conductivity may be formed into the first to third source electrodes SE1 to SE3, the first to third drain electrodes DE1 to DE3, the lower electrode LE, and the first and second electrodes PE1 and PE2.

Referring to FIGS. 7 - 20, the second insulating layer INS2 is formed on the first to third active patterns ACT1 to ACT3, the first to third source electrodes SE1 to SE3, the first to third drain electrodes DE1 to DE3, the lower electrode LE, and the first and second electrodes PE1 and PE2. The second insulating layer INS2 may include an inorganic insulating layer including inorganic material.

The third conductive layer C3 is formed on the second insulating layer INS2. For example, the third conductive layer C3 may be provided in a double-layer structure stacked in a sequence of titanium and/or copper, but the present disclosure is not limited thereto. The third conductive layer C3 may include the first to third gate electrodes GE1 to GE3, and the first to third additional conductive patterns ACP1 to ACP3.

Referring to FIGS. 7 - 21, the third insulating layer INS3 is formed on the overall surface of the third conductive layer C3. The third insulating layer INS3 may be located on the third conductive layer C3 and the second insulating layer INS2 in the first area A1 and the second area A2. The third insulating layer INS3 may be formed of an inorganic insulating layer including inorganic material. For example, the third insulating layer INS3 may include an inorganic insulating layer including silicon oxynitride (SiOₓN_{y}).

The third insulating layer INS3 may be patterned to include a plurality of contact holes CH through which some of the components located thereunder are exposed.

Referring to FIGS. 7 - 22, the fourth conductive layer C4 is formed on the third insulating layer INS3. The fourth conductive layer C4 may be located in the first area A1 and the second area A2. For example, the fourth conductive layer C4 may be provided in a multilayer structure stacked in a sequence of titanium, copper, and/or indium tin oxide, but the present disclosure is not limited thereto.

The fourth conductive layer C4 may include the first horizontal power line PL1b, the first dummy power line PL1c, the second horizontal power line PL2b, the second dummy power line PL2c, the first to fourth connection patterns CNP1 to CNP4, the upper electrode UE, the dummy electrode DME, and the scan line SC.

The fourth insulating layer INS4 described with reference to FIG. 12 may be formed on the fourth conductive layer C4.

In the first sub-pixel SPX1 (or the display device DD) formed by the aforementioned fabrication method, the substrate SUB is partitioned into the first area A1 in which the pixel circuit PXC (or pixel circuit layer (refer to "PCL" of FIG. 4))is located and the second area A2 in which the emission component EMU (or the light-emitting-element layer (refer to "LDL" of FIG. 4))is located, and some components of the pixel circuit PXC and some components of the emission component EMU are formed through the same process. Consequently, the fabrication efficiency may be enhanced.

FIG. 23 illustrates the first sub-pixel SPX1, and is a schematic cross-sectional view taken along the line I-I' of FIG. 7.

With regard to the example of FIG. 23, the following description will be focused on differences from that of the foregoing examples, to avoid redundant explanation.

Referring to FIGS. 7 and 23, the first sub-pixel SPX1 may further include an upper substrate U_SUB located on the fourth conductive layer C4 and the fourth insulating layer INS4.

The upper substrate U_SUB may include a base layer BSL, an optical layer LCL, a fifth insulating layer INS5, a sixth insulating layer INS6, and a second bank BNK2. The optical layer LCL may include a color filter layer CFL and a color conversion layer CCL.

The base layer BSL may be a rigid and/or flexible substrate, and the material or properties thereof are not particularly limited. The base layer BSL may be formed of the same material as that of the substrate SUB, or may be formed of material different from that of the substrate SUB.

The color filter layer CFL may be located on one surface of the base layer BSL in a direction opposite to the third direction DR3 to face the first and second electrodes PE1 and PE2. The color filter layer CFL may include a color filter CF corresponding to the first emission area EMA1. For example, the color filter layer CFL may include a first color filter CF1 located on the color conversion layer CCL of the first sub-pixel SPX1, a second color filter CF2 located on the color conversion layer of the second sub-pixel (refer to "SPX2" of FIG. 6) adjacent to the first sub-pixel SPX1, and a third color filter CF3 located on the color conversion layer of the third sub-pixel (refer to "SPX3" of FIG. 6) adjacent to the second sub-pixel SPX2.

The first color filter CF1 of the color filter layer CFL may be located on one surface of the base layer BSL to correspond to the light-emitting elements LD in the first emission area EMA1. The first, second, and third color filters CF1, CF2, and CF3 of the color filter layer CFL may be located to overlap each other in the non-emission area NEA, thus functioning as a light blocking component.

The fifth insulating layer INS5 may be located on the color filter layer CFL. The fifth insulating layer INS5 may be located on the color filter layer CFL and cover the color filter layer CFL, thus protecting the color filter layer CFL. The fifth insulating layer INS5 may be an inorganic insulating layer including inorganic material and/or an organic insulating layer including organic material.

The second bank BNK2 and the color conversion layer CCL may be positioned on one surface of the fifth insulating layer INS5 in the direction opposite to the third direction DR3.

The second bank BNK2 may be positioned on the first bank BNK1 in the non-emission area NEA and overlap the first bank BNK1 in the third direction DR3. The color conversion layer CCL may be positioned on the first and second electrodes PE1 and PE2 and the light-emitting elements LD in the first emission area EMA1 and overlap the first and second electrodes PE1 and PE2 and the light-emitting elements LD.

The second bank BNK2 may be a dam structure which encloses the first emission area EMA1 of the first sub-pixel SPX1 and defines a position at which the color conversion layer CCL is to be supplied, thus eventually defining the first emission area EMA1. The second bank BNK2 may include light blocking material. For example, the second bank BNK2 may be a black matrix, but the present disclosure is not limited thereto. The second bank BNK2 may include at least one light blocking material and/or reflective material, and allow light emitted from the color conversion layer CCL to more reliably travel in the image display direction (e.g., the third direction DR3) of the display device DD, thus enhancing the light output efficiency of the color conversion layer CCL.

The color conversion layer CCL may include color conversion particles QD corresponding to a specific color. For example, the color conversion layer CCL may include color conversion particles QD which convert a first color of light emitted from the light-emitting elements LD into a second color of light (a specific color of light, or light having excellent color reproducibility).

In the case in which the first sub-pixel SPX1 is a red sub-pixel, the color conversion layer CCL of the first sub-pixel SPX1 may include color conversion particles QD formed of red quantum dots which convert a first color of light emitted from the light-emitting elements LD into a second color of light (e.g., red light).

In the case in which the first sub-pixel SPX1 is a green sub-pixel, the color conversion layer CCL of the first sub-pixel SPX1 may include color conversion particles QD formed of green quantum dots which convert a first color of light emitted from the light-emitting elements LD into a second color of light (e.g., green light).

In the case in which the first sub-pixel SPX1 is a blue sub-pixel, the color conversion layer CCL of the first sub-pixel SPX1 may include color conversion particles QD formed of blue quantum dots which convert a first color of light emitted from the light-emitting elements LD into a second color of light (e.g., blue light). In the case in which the first sub-pixel SPX1 is a blue sub-pixel, there may be provided a light scattering layer including light scattering particles SCT, in place of the color conversion layer CCL including the color conversion particles QD. For example, in the case in which the light-emitting elements LD emit blue-based light, the first sub-pixel SPX1 may include a light scattering layer including light scattering particles SCT. The light scattering layer may be omitted. In the case in which the first sub-pixel SPX1 is a blue sub-pixel, there may be provided a transparent polymer, in place of the color conversion layer CCL.

The sixth insulating layer INS6 may be located on the overall surfaces of the second bank BNK2 and the color conversion layer CCL.

The sixth insulating layer INS6 may be formed of an inorganic insulating layer including inorganic material and/or an organic insulating layer including organic material. The sixth insulating layer INS6 may be located on the color conversion layer CCL and protect the color conversion layer CCL from external water and/or moisture so that the reliability of the color conversion layer CCL can be further enhanced.

In the first sub-pixel SPX1, the color conversion layer CCL and the color filter layer CFL may be located on the light-emitting elements LD so that light having excellent light reproducibility can be emitted through the color conversion layer CCL and the color filter layer CFL, whereby the light output efficiency can be enhanced.

In accordance with one or more embodiments, a pixel circuit and an emission component may be located on one surface of an identical (e.g., the same) substrate, thus making it possible to implement a display device having a slim structure with a reduced thickness.

Furthermore, components included in the pixel circuit and components included in the emission component may be formed through the same process, whereby fabrication efficiency of the display device can be improved.

The aspects of the present invention are not limited by the foregoing, and other various aspects are anticipated herein.

While various embodiments have been described above, those skilled in the art will appreciate that various modifications, additions and substitutions are possible, without departing from the scope of the present invention as defined by the claims.

## Claims

1. A display device, comprising a sub-pixel comprising a first area (A1) and a second area (A2), the sub-pixel comprising:
a pixel circuit (PXC) in the first area, and comprising a transistor (T1, T2, T3) located on a substrate; and
an emission component in the second area, and comprising a light-emitting element (LD), and a first electrode (PE1) and a second electrode (PE2) electrically connected to the light-emitting element (LD),
the transistor comprising an active pattern (ACT1, ACT2, ACT3) located on the substrate, a source electrode (SE1, SE2, SE3) connected to a first side of the active pattern, a drain electrode (DE1, DE2, DE3) connected to a second side of the active pattern, and a gate electrode (GE1, GE2, GE3) located on the active pattern, and
the active pattern (ACT1, ACT2, ACT3), the source electrode (SE1, SE2, SE3), the drain electrode (DE1, DE2, DE3), the first electrode (PE1) and the second electrode (PE2) being provided in the same intrinsic semiconductor layer (SCL),
wherein the active pattern is an area of the intrinsic semiconductor layer which is not doped with impurities, and each of the source electrode, the drain electrode, the first electrode, and the second electrode is an area of the intrinsic semiconductor layer which is doped with an impurity to have conductivity,
wherein the pixel circuit comprises a bottom metal layer (BML) located on the substrate, a first insulating layer (INS1) located on the bottom metal layer, the active pattern located on the first insulating layer, the gate electrode located on the source electrode, the drain electrode, and the active pattern, and a source-drain conductive layer located on the gate electrode,
wherein the emission component comprises a first alignment electrode (ALE1) and a second alignment electrode (ALE2) located on the substrate, the first insulating layer located on the first and the second alignment electrodes, the light-emitting element located on the first insulating layer, the first electrode located on the light-emitting element and connected to a first end of the light-emitting element, and the second electrode located on the light-emitting element and connected to a second end of the light-emitting element, and
wherein the bottom metal layer (BML), the first alignment electrode (ALE1), and the second alignment electrode (ALE2) are in the same layer.

2. The display device according to claim 1, wherein the first and the second electrodes are spaced from the active pattern, the source electrode, and the drain electrode.

3. The display device according to claim 1,
wherein the second area comprises an emission area (EMA1, EMA2, EMA3) from which light is emitted, and a non-emission area (NEA) adjacent to the emission area,
wherein the emission component comprises a first bank (BNK1) in the non-emission area and comprising an opening (OP) corresponding to the emission area, and
wherein at least a portion of the first bank overlaps each of the first and the second alignment electrodes.

4. The display device according to claim 1,
wherein the sub-pixel further comprises a storage capacitor (Cst) comprising a lower electrode (LE) located on the substrate, and an upper electrode (UE) located on the lower electrode and overlapping the lower electrode,
wherein the lower electrode is in the same layer as the active pattern, the source electrode, the drain electrode, and the first and the second electrodes,
wherein the sub-pixel further comprises a first power line (PL1) configured to receive a first driving voltage (VDD), and a second power line (PL2) configured to receive a second driving voltage (VSS) different from the first driving voltage, and
wherein the first electrode is electrically connected to the upper electrode, and the second electrode is electrically connected to the second power line.

5. The display device according to claim 4,
wherein the first power line comprises a first vertical power line (PL1a) configured of the bottom metal layer, a first horizontal power line (PL1b) configured of the source-drain conductive layer, and a first dummy power line (PL1c) overlapping the first vertical power line and configured of the source-drain conductive layer, and
wherein the second power line comprises a second vertical power line (PL2a) formed of the bottom metal layer, a second horizontal power line (PL2b) formed of the source-drain conductive layer, and a second dummy power line (PL2c) integrally formed with the second horizontal power line and extending in a direction different from the second horizontal power line.

6. The display device according to claim 5,
wherein the first vertical power line, the first horizontal power line, and the first dummy power line are electrically connected to each other, and
wherein the second vertical power line, the second horizontal power line, and the second dummy power line are electrically connected to each other.

## Patentansprüche

1. Anzeigevorrichtung, umfassend ein Subpixel, umfassend einen ersten Bereich (A1) und einen zweiten Bereich (A2), wobei das Subpixel umfasst:
eine Pixelschaltung (PXC) in dem ersten Bereich, und umfassend einen Transistor (T1, T2, T3), der sich auf einem Substrat befindet; und
eine Emissionskomponente in dem zweiten Bereich, und umfassend ein lichtemittierendes Element (LD) und eine erste Elektrode (PE1) und eine zweite Elektrode (PE2), die elektrisch mit dem lichtemittierenden Element (LD) verbunden sind,
wobei der Transistor ein aktives Muster (ACT1, ACT2, ACT3), das sich auf dem Substrat befindet, eine Source-Elektrode (SE1, SE2, SE3), die mit einer ersten Seite des aktiven Musters verbunden ist, eine Drain-Elektrode (DE1, DE2, DE3), die mit einer zweiten Seite des aktiven Musters verbunden ist, und eine Gate-Elektrode (GE1, GE2, GE3), die sich auf dem aktiven Muster befindet, umfasst, und
wobei das aktive Muster (ACT1, ACT2, ACT3), die Source-Elektrode (SE1, SE2, SE3), die Drain-Elektrode (DE1, DE2, DE3), die erste Elektrode (PE1) und die zweite Elektrode (PE2) in derselben intrinsischen Halbleiterschicht (SCL) bereitgestellt sind,
wobei das aktive Muster ein Bereich der intrinsischen Halbleiterschicht ist, der nicht mit Verunreinigungen dotiert ist, und
jede der Source-Elektrode, der Drain-Elektrode, der ersten Elektrode und der zweiten Elektrode ein Bereich der intrinsischen Halbleiterschicht ist, der mit einer Verunreinigung dotiert ist, um Leitfähigkeit aufzuweisen,
wobei die Pixelschaltung eine untere Metallschicht (BML), die sich auf dem Substrat befindet, eine erste Isolierschicht (INS1), die sich auf der unteren Metallschicht befindet, das aktive Muster, das sich auf der ersten Isolierschicht befindet, die Gate-Elektrode, die sich auf der Source-Elektrode befindet, die Drain-Elektrode und das aktive Muster und eine leitfähige Source-Drain-Schicht, die sich auf der Gate-Elektrode befindet, umfasst,
wobei die Emissionskomponente eine erste Ausrichtungselektrode (ALE1) und eine zweite Ausrichtungselektrode (ALE2), die sich auf dem Substrat befinden, die erste Isolierschicht, die sich auf der ersten und der zweiten Ausrichtungselektrode befindet, das lichtemittierende Element, das sich auf der ersten Isolierschicht befindet, die erste Elektrode, die sich auf dem lichtemittierenden Element befindet und mit einem ersten Ende des lichtemittierenden Elements verbunden ist, und die zweite Elektrode, die sich auf dem lichtemittierenden Element befindet und mit einem zweiten Ende des lichtemittierenden Elements verbunden ist, umfasst und
wobei die untere Metallschicht (BML), die erste Ausrichtungselektrode (ALE1) und die zweite Ausrichtungselektrode (ALE2) in derselben Schicht sind.

2. Anzeigevorrichtung nach Anspruch 1, wobei die erste und die zweite Elektrode von dem aktiven Muster, der Source-Elektrode und der Drain-Elektrode beabstandet sind.

3. Anzeigevorrichtung nach Anspruch 1,
wobei der zweite Bereich einen Emissionsbereich (EMA1, EMA2, EMA3), aus dem Licht emittiert wird, und einen an den Emissionsbereich angrenzenden Nichtemissionsbereich (NEA) umfasst,
wobei die Emissionskomponente eine erste Bank (BNK1) in dem Nichtemissionsbereich umfasst und eine Öffnung (OP), die dem Emissionsbereich entspricht, umfasst und
wobei mindestens ein Abschnitt der ersten Bank jede der ersten und der zweiten Ausrichtungselektrode überlappt.

4. Anzeigevorrichtung nach Anspruch 1,
wobei das Subpixel ferner einen Speicherkondensator (Cst) umfasst, der eine auf dem Substrat befindliche untere Elektrode (LE) und eine auf der unteren Elektrode befindliche und die untere Elektrode überlappende obere Elektrode (UE) umfasst,
wobei die untere Elektrode in derselben Schicht wie das aktive Muster, die Source-Elektrode, die Drain-Elektrode und die erste und die zweite Elektrode ist,
wobei das Subpixel ferner eine erste Stromleitung (PL1), die dazu konfiguriert ist, eine erste Treiberspannung (VDD) zu empfangen, und eine zweite Stromleitung (PL2), die dazu konfiguriert ist, eine zweite Treiberspannung (VSS) zu empfangen, die sich von der ersten Treiberspannung unterscheidet, umfasst und
wobei die erste Elektrode elektrisch mit der oberen Elektrode verbunden ist und die zweite Elektrode elektrisch mit der zweiten Stromleitung verbunden ist.

5. Anzeigevorrichtung nach Anspruch 4,
wobei die erste Stromleitung eine erste vertikale Stromleitung (PL1a), die aus der unteren Metallschicht konfiguriert ist, eine erste horizontale Stromleitung (PL1b), die aus der leitfähigen Source-Drain-Schicht konfiguriert ist, und eine erste Blindstromleitung (PL1c), die die erste vertikale Stromleitung überlappt und aus der Source-Drain-Leitungsschicht konfiguriert ist, umfasst und
wobei die zweite Stromleitung eine zweite vertikale Stromleitung (PL2a), die aus der unteren Metallschicht gebildet ist, eine zweite horizontale Stromleitung (PL2b), die aus der leitfähigen Source-Drain-Schicht gebildet ist, und eine zweite Blindstromleitung (PL2c), die integral mit der zweiten horizontalen Stromleitung gebildet ist und sich in einer Richtung erstreckt, die sich von der zweiten horizontalen Stromleitung unterscheidet, umfasst.

6. Anzeigevorrichtung nach Anspruch 5,
wobei die erste vertikale Stromleitung, die erste horizontale Stromleitung und die erste Blindstromleitung elektrisch miteinander verbunden sind, und
wobei die zweite vertikale Stromleitung, die zweite horizontale Stromleitung und die zweite Blindstromleitung elektrisch miteinander verbunden sind.

## Revendications

1. Dispositif d'affichage, comprenant un sous-pixel comprenant une première zone (A1) et une seconde zone (A2), le sous-pixel comprenant :
un circuit de pixel (PXC) dans la première zone, et comprenant un transistor (T1, T2, T3) situé sur un substrat ; et
un composant d'émission dans la seconde zone, et comprenant un élément électroluminescent (LD), et une première électrode (PE1) et une seconde électrode (PE2) électriquement connectées à l'élément électroluminescent (LD),
le transistor comprenant un motif actif (ACT1, ACT2, ACT3) situé sur le substrat, une électrode de source (SE1, SE2, SE3) connectée à un premier côté du motif actif, une électrode de drain (DE1, DE2, DE3) connectée à un second côté du motif actif, et une électrode de grille (GE1, GE2, GE3) située sur le motif actif, et
le motif actif (ACT1, ACT2, ACT3), l'électrode de source (SE1, SE2, SE3), l'électrode de drain (DE1, DE2, DE3), la première électrode (PE1) et la seconde électrode (PE2) étant ménagées dans la même couche semi-conductrice intrinsèque (SCL),
dans lequel le motif actif est une zone de la couche semi-conductrice intrinsèque qui n'est pas dopée avec des impuretés, et
chacune de l'électrode de source, de l'électrode de drain, de la première électrode et de la seconde électrode est une zone de la couche semi-conductrice intrinsèque qui est dopée avec une impureté pour présenter une conductivité,
dans lequel le circuit de pixel comprend une couche métallique inférieure (BML) située sur le substrat, une première couche isolante (INS1) située sur la couche métallique inférieure, le motif actif situé sur la première couche isolante, l'électrode de grille située sur l'électrode de source, l'électrode de drain et le motif actif, et une couche conductrice source-drain située sur l'électrode de grille,
dans lequel le composant d'émission comprend une première électrode d'alignement (ALE1) et une seconde électrode d'alignement (ALE2) situées sur le substrat, la première couche isolante située sur la première et la seconde électrode d'alignement, l'élément électroluminescent situé sur la première couche isolante, la première électrode située sur l'élément électroluminescent et connectée à une première extrémité de l'élément électroluminescent, et la seconde électrode située sur l'élément électroluminescent et connectée à une seconde extrémité de l'élément électroluminescent, et
dans lequel la couche métallique inférieure (BML), la première électrode d'alignement (ALE1) et la seconde électrode d'alignement (ALE2) sont dans la même couche.

2. Dispositif d'affichage selon la revendication 1, dans lequel les première et seconde électrodes sont espacées du motif actif, de l'électrode de source et de l'électrode de drain.

3. Dispositif d'affichage selon la revendication 1, dans lequel la seconde zone comprend une zone d'émission (EMA1, EMA2, EMA3) à partir de laquelle est émise de la lumière, et une zone de non-émission (NEA) adjacente à la zone d'émission, dans lequel le composant d'émission comprend un premier banc (BNK1) dans la zone de non-émission et comprenant une ouverture (OP) correspondant à la zone d'émission, et
dans lequel au moins une partie dudit premier banc chevauche chacune desdites première et seconde électrodes d'alignement.

4. Dispositif d'affichage selon la revendication 1,
dans lequel le sous-pixel comprend en outre un condensateur de stockage (Cst) comprenant une électrode basse (LE) située sur le substrat, et une électrode haute (UE) située sur l'électrode basse et chevauchant l'électrode basse,
dans lequel l'électrode basse est dans la même couche que le motif actif, l'électrode de source, l'électrode de drain et les première et seconde électrodes,
dans lequel le sous-pixel comprend en outre une première ligne d'alimentation (PL1) conçue pour recevoir une première tension d'attaque (VDD), et une seconde ligne d'alimentation (PL2) conçue pour recevoir une seconde tension d'attaque (VSS) différente de la première tension d'attaque, et
dans lequel la première électrode est électriquement connectée à l'électrode haute, et la seconde électrode est électriquement connectée à la seconde ligne d'alimentation.

5. Dispositif d'affichage selon la revendication 4,
dans lequel la première ligne d'alimentation comprend une première ligne d'alimentation verticale (PL1a) conçue de la couche métallique inférieure, une première ligne d'alimentation horizontale (PL1b) conçue de la couche conductrice source-drain, et une première ligne d'alimentation factice (PL1c) chevauchant la première ligne d'alimentation verticale et conçue de la couche conductrice source-drain, et
dans lequel la seconde ligne d'alimentation comprend une seconde ligne d'alimentation verticale (PL2a) formée de la couche métallique inférieure, une seconde ligne d'alimentation horizontale (PL2b) formée de la couche conductrice source-drain, et une seconde ligne d'alimentation fictive (PL2c) intégralement formée avec la seconde ligne d'alimentation horizontale et s'étendant dans une direction différente de celle de la seconde ligne d'alimentation horizontale.

6. Dispositif d'affichage selon la revendication 5,
dans lequel la première ligne d'alimentation verticale, la première ligne d'alimentation horizontale et la première ligne d'alimentation factice sont connectées électriquement les unes aux autres, et
dans lequel la seconde ligne d'alimentation verticale, la seconde ligne d'alimentation horizontale et la seconde ligne d'alimentation fictive sont connectées électriquement les unes aux autres.
